# EUROPÄISCHE PATENTSCHRIFT

(11) **EP 2 504 713 B1**
(45) Veröffentlichungstag und Bekanntmachung des Hinweises auf die Patenterteilung: **23.10.2013**
(21) Anmeldenummer: 10779016.4
(22) Anmeldetag: 18.11.2010
(51) Int. Cl.: G01R 31/40, G05F 1/67

(54) **BELASTUNGSZUSTANDSBESTIMMER, LASTANORDNUNG, LEISTUNGSVERSORGUNGSSCHALTUNG UND VERFAHREN ZUM BESTIMMEN EINES BELASTUNGSZUSTANDES EINER ELEKTRISCHEN LEISTUNGSQUELLE**
LOAD STATE DETERMINER, LOAD ASSEMBLY, POWER SUPPLY CIRCUIT AND METHOD FOR DETERMINING A LOAD STATE OF AN ELECTRICAL POWER SOURCE
DISPOSITIF DE DÉTERMINATION D'ÉTAT DE CHARGE, ENSEMBLE DE CHARGE, CIRCUIT D'ALIMENTATION EN PUISSANCE ET PROCÉDÉ DE DÉTERMINATION D'UN ÉTAT DE CHARGE D'UNE SOURCE DE PUISSANCE ÉLECTRIQUE

(30) Priorität: 27.11.2009 DE 102009047247
(43) Veröffentlichungstag der Anmeldung: 03.10.2012
(73) Patentinhaber: Hahn-Schickard-Gesellschaft für angewandte Forschung e.V., 78052 Villingen-Schwenningen (DE)
(72) Erfinder: MAURATH, Dominic, 78052 Villingen-Schwenningen (DE); FOLKMER, Bernd, 78052 Villingen-Schwenningen (DE)
(74) Vertreter: Burger, Markus
(86) Internationale Anmeldenummer: PCT/EP2010/067763
(87) Internationale Veröffentlichungsnummer: WO 2011/064137

(56) Entgegenhaltungen:
- WO-A1-2007/118277
- DE-A1-102007 059 349
- FR-A1- 2 618 922
- US-A- 3 489 915
- US-B1- 7 105 982
- CHRISTIAN PETERS ET AL: "A CMOS integrated voltage and power efficient AC/DC converter for energy harvesting applications; A CMOS integrated voltage and power efficient ac/dc converter for energy harvesting applications", JOURNAL OF MICROMECHANICS & MICROENGINEERING, INSTITUTE OF PHYSICS PUBLISHING, BRISTOL, GB, Bd. 18, Nr. 10, 1. Oktober 2008 (2008-10-01), Seite 104005, XP020144988, ISSN: 0960-1317

## Beschreibung

### Hintergrund der Erfindung

Ausführungsbeispiele gemäß der Erfindung beziehen sich auf einen Belastungszustandsbestimmer zum Bestimmen eines Belastungszustandes einer elektrischen Leistungsquelle, die einen Innenwiderstand aufweist. Weitere Ausführungsbeispiele gemäß der Erfindung beziehen sich auf eine Lastanordnung. Weitere Ausführungsbeispiele gemäß der Erfindung beziehen sich auf eine Leistungsversorgungsanordnung. Weitere Ausführungsbeispiele gemäß der Erfindung beziehen sich auf ein Verfahren zum Bestimmen eines Belastungszustandes einer elektrischen Leistungsquelle, die einen Innenwiderstand aufweist.

Allgemein gesprochen kann man sagen, dass sich Ausführungsbeispiele gemäß der Erfindung auf eine Elektronikschnittstelle für Energie-Ernter (üblicherweise auch als "energy harvester" bezeichnet) beziehen.

Elektrische Generatoren werden in vielen Fällen verwendet, um elektrische Energie basierend auf einer anderen Energieform, z.B. mechanischer Energie, einem Temperaturgradienten, chemisch gespeicherter Energie oder Strahlungsenergie zu erhalten. Für einen optimalen Betrieb von Generatoren ist es wünschenswert eine Lastanpassung zu haben. Diese Anpassung ist wünschenswert (bzw. in manchen Fällen sogar erforderlich), da die generierte Spannung eines Generators (oder allgemein: einer Leistungsquelle) sich nur über dessen oft großen Innenwiderstand (oder allgemein: Quellenimpedanz) an dessen Klemmen (also an den Quellen des Generators, oder allgemeiner den Klemmen der Leistungsquelle) abgreifen lässt. Um diese Anpassung bzw. Lastanpassung zu erreichen, wird an den Generator typischerweise eine Schaltung, z.B. ein Leistungswandler bzw. Spannungswandler, geschaltet, welcher den Generator derart belasten soll, dass dieser durch eine somit optimale Belastung die maximal mögliche Leistung abgibt.

Bei den betrachteten und für ein Ernten von Energie (üblicherweise auch als "energy harvesting" bezeichnet) typischen Generatoren verursacht der Laststrom über dem Innenwiderstand (bzw. der Quellenimpedanz) einen Spannungsabfall. Somit reduziert sich die Quellenspannung (z.B. die Klemmenspannung an von außen zugänglichen Klemmen des Generators). Nur bei einer bestimmten Kombination aus Laststrom und Innenwiderstand (bzw. Quellenimpedanz), bzw. bei eben einer bestimmten Klemmenspannung, ist die Leistungsabgabe maximal.

Eine Lastanpassung ist im Allgemeinen dann erreicht, wenn die Lastimpedanz (also das Verhältnis zwischen Spannung und Strom an der Last) den Wert der komplex konjugierten Quellenimpedanz (Impedanz des Generators) hat. Die Lastanpassung wird daher oft als Impedanzanpassung bezeichnet.

Mit einer Lastanpassung bzw. Impedanzanpassung ist somit typischerweise verbunden, dass bei dieser angepassten Belastung die Klemmenspannung des Generators gerade seiner halben momentanen Leerlaufspannung entspricht. Da Generatoren aber im Allgemeinen, und insbesondere bei Energie-erntenden Anwendungen (üblicherweise auch als "energy harvesting"-Anwendungen bezeichnet), von externen Ereignissen - beispielsweise Schwingungen und Stößen - angeregt werden, ist der zeitliche Verlauf der daraus resultierenden Leerlaufspannung unbekannt.

In Anbetracht dessen wurden verschiedene Konzepte entwickelt, um einen elektrischen Generator möglichst effizient zu betreiben. Das übergeordnete Ziel ist dabei meist der Betrieb einer Quelle (z.B. eines Generators) im optimalen Arbeitspunkt bzw. Lastpunkt, so dass eine maximale Ausgangsleistung verfügbar ist.

Viele herkömmliche Systeme versuchen, dies über Gradienten-basierte Regelalgorithmen in Kombination mit einer wiederholten oder permanenten Leistungsmessung zu erreichen. Für Details diesbezüglich wird beispielsweise auf die US 5,867,011, die US 7,053,506 und die US 6,844,739 verwiesen, die jeweils eine Gradientenmethode und eine Leistungsmessung beschreiben. Diese Leistungsermittlung geschieht dabei über eine gleichzeitige Strom- und Spannungsmessung, wobei die ermittelten Werte anschließend multipliziert werden.

Andere Herangehensweisen versuchen, über bestimmte Annahmen mit einem komplexen Regelalgorithmus die Ausgangsleistung zu maximieren. Details diesbezüglich sind beispielsweise in der Veröffentlichung "Optimized piezoelectric energy harvesting circuit using step-down converter in discontinous conduction mode" von G. K. Ottmann, H. F. Hofmann und G.A. Lesieutre (veröffentlicht in: IEEE Trans. Power Electron., vol. 18, pp. 696, March 2003) und in der Veröffentlichung "Buck-boost converter for sensorless power optimization of piezoelectric energy harvester," von E. Lefeuvre, D. Audigier und D. Guyomar (veröffentlicht in: IEEE Trans. Power Electron, vol, 22, pp. 2018, Sept. 2007) beschrieben.

Diese Herangehensweisen sind jedoch sehr komplex, wodurch sich in vielen Fällen deren hoher Eigenleistungsverbrauch negativ auswirkt.

Im Übrigen gibt es einige Methoden zur indirekten Messung der Leerlaufspannung aus anderen Anwendungsgebieten, wie beispielsweise der Batterietechnik:
1. Messen in unbelasteten Pausen (siehe z.B. US 7,557,540 B2):
   In Phasen, in denen der Generator (bzw. die Quelle) nicht belastet ist, wird die Spannung gemessen. Dies geschieht in Belastungspausen, oder am Beginn der Inbetriebnahme. Dabei wird angenommen, dass sich die Leerlaufspannung des Generators nicht wesentlich ändert. Kurz zusammengefasst kann man sagen, dass bei dem Konzept gemäß der US 7,557,540 B1 eine Messung nicht unter Last erfolgt.
2. Hilfs-Generator im permanenten Leerlauf zur Messung der Leerlaufspannung (vgl. DE 199 04 561):
   Zusätzlich zum aktiven bzw. genutzten belasteten Generator wird ein zweiter Generator betrieben, der dem belasteten Generator ähnlich ist. Dieser zweite Generator wird im Leerlauf betrieben und über eine Spannungsmessung wird eine Leerlaufspannung des belasteten Generators ermittelt. Somit beschreibt die DE 199 04 561 insgesamt die Verwendung eines "Hilfsmoduls", welches unbelastet ist.
3. Testmessungen mit verschiedenen Lasten (siehe z.B. EP 100 3234 A1 und US 6,737,831 B2):
   Es werden bekannte Testbelastungen an den Generator angeschlossen. Durch einen Vergleich der Klemmspannungen bzw. Klemmenspannungen kann auf die aktuelle Leerlaufspannung zurückgerechnet werden. So beschreibt die EP 100 3234 A1 eine Testmessung mit verschiedenen Test-Lasten. Die US 6,737,831 B2 beschreibt eine Strominjektion und Spannungsdifferenzmessung.

Weiterhin offenbart die FR 2 618 922 A1 ein Verfahren zur Anpassung eines Generators an eine Last. Insbesonders wird dabei eine Ausgangsimpedanz eines Generators auf einen gewünschten Wert eingestellt, wobei die Verluste gering gehalten werden. Zu diesem Zweck ist ein Verstärker mit geringer Ausgangsimpedanz derart beschaltet, dass sich ein gewünschter Zusammenhang zwischen Laststrom und Ausgangsspannung ergibt.

Die US 3 489 915 beschreibt einen Solarzellen-Batterielader welcher durch Lastanpassung die verfügbare Leistung maximiert und die maximale Leistung mit Hilfe einer Auswerteschaltung feststellt. Aufgrund der nicht-linearen Kennlinie des Solarzellengenerators (unbekannte und unkonstante Quellenimpedanz) sind jedoch aufwändigere Bestimmungskonzepte und dadurch bedingt eine kompliziertere Auswerteschaltung mit Multipliziererschaltungen nötig.

In Anbetracht der herkömmlichen Konzepte zur Bestimmung der Leerlaufspannung eines Generators ist die Aufgabe der vorliegenden Erfindung, ein Konzept zur Bestimmung eines Belastungszustandes oder einer Leerlaufspannung einer Leistungsquelle zu schaffen, das mit geringem Aufwand implementierbar ist und dennoch eine aussagekräftige Information im Hinblick auf den Lastzustand liefert.

### Zusammenfassung der Erfindung

Diese Aufgabe wird durch einen Belastungszustandsbestimmer gemäß Anspruch 1, eine Lastanordnung gemäß Anspruch 9, eine Leistungsversorgungsschaltung gemäß Anspruch 10 und ein Verfahren zum Bestimmen eines Belastungszustandes einer elektrischen Leistungsquelle gemäß Anspruch 12 gelöst.

Ein Ausführungsbeispiel gemäß der Erfindung schafft einen Belastungszustandsbestimmer zum Bestimmen eines Belastungszustandes einer elektrischen Leistungsquelle, die eine bekannte Quellenimpedanz (zum Beispiel einen Innenwiderstand) aufweist. Der Belastungszustandsbestimmer umfasst eine Spannungsabfall-Bestimmungsschaltung, die ausgelegt ist, um basierend auf einer Erfassung eines unter Last von der Leistungsquelle an eine Last gelieferten Momentanstroms eine elektrische Größe zu liefern, die einen Spannungsabfall an der Quellenimpedanz (zum Beispiel dem Innenwiderstand) der Leistungsquelle beschreibt. Der Belastungszustandsbestimmer umfasst ferner eine Auswerteschaltung, die ausgelegt ist, um basierend auf der elektrischen Größe, die den Spannungsabfall an dem Innenwiderstand der Leistungsquelle beschreibt, und einer elektrischen Größe, die eine Klemmenspannung der Leistungsquelle beschreibt, ein Lastzustand-Signal zu erhalten, das eine Information über eine momentane Relation zwischen der Klemmenspannung der Leistungsquelle und einer Leerlaufspannung der Leistungsquelle trägt.

Dieses Ausführungsbeispiel gemäß der Erfindung basiert auf der Erkenntnis, dass es möglich ist, eine Information über den Belastungszustand unter Verwendung von elektrischen Größen, die zu einem gemeinsamen Zeitpunkt und ohne zwischenzeitliche Veränderung des Lastzustandes ermittelt werden, bestimmt werden kann, indem basierend auf einer Messung eines an die Last gelieferten Momentanstroms eine elektrische Größe erzeugt wird, die den Spannungsabfall an dem Innenwiderstand der Leistungsquelle beschreibt. Die elektrische Größe kann dann mit einer elektrischen Größe, die die Klemmenspannung beschreibt, verknüpft (zum Beispiel verglichen) werden, um so die Information über die momentane Relation zwischen der Klemmenspannung der Leistungsquelle und der Leerlaufspannung der Leistungsquelle zu erhalten.

Das erfindungsgemäße Konzept ist im Übrigen einfach, insbesondere mit geringem Teileaufwand, realisierbar, da es erfindungsgemäß nicht erforderlich ist, Messgrößen, die zu zwei verschiedenen Zeitpunkten ermittelt werden, miteinander zu verknüpfen, um eine Information über die Relation zwischen der Klemmenspannung der Leistungsquelle und der Leerlaufspannung der Leistungsquelle zu erhalten. Vielmehr wird es bei Verwendung des erfindungsgemäßen Konzepts bevorzugt, elektrische Größen zu einem gemeinsamen Zeitpunkt auszuwerten. Dadurch ist eine analoge Verarbeitung mit geringem Aufwand möglich, ohne dass dabei komplexe und leistungshungrige analoge Speicherglieder oder eine komplexe digitale Verarbeitungsschaltung erforderlich sind.

Außerdem ist es bei dem erfindungsgemäßen Konzept nicht erforderlich, die Last zur Durchführung einer Messung der Leerlaufspannung bzw. zur Bestimmung des Belastungszustandes zu verändern, da erfindungsgemäß lediglich der momentan an die Last gelieferte Momentanstrom und die momentane Klemmenspannung gemessen bzw. verarbeitet werden müssen, um die Information über den Lastzustand zu erhalten. Insbesondere eignet sich das Erfindungskonzept somit auch besonders gut zur Bestimmung des Lastzustandes bei Leistungsquellen, deren Leerlaufspannung sich permanent oder zumindest sehr häufig ändert.

Weitere Vorteile des erfindungsgemäßen Konzept werden im Übrigen später noch detailliert erläutert.

Ein weiteres Ausführungsbeispiel gemäß der Erfindung schafft eine Lastanordnung mit einem Belastungszustandsbestimmer, wie er vorstehend beschrieben wurde. Die Lastanordnung umfasst ferner eine einstellbare Lastschaltung und einen Lasteinsteller. Die Spannungsabfall-Bestimmungsschaltung des Belastungszustandsbestimmers ist dabei ausgelegt, um den von der Leistungsquelle an die einstellbare Lastschaltung gelieferten Momentanstrom zu erfassen. Der Lasteinsteller ist ferner ausgelegt, um die Last in Abhängigkeit von dem durch den Belastungszustandsbestimmer gelieferten Lastzustand-Signal so einzustellen, dass eine Leistungsanpassung zwischen der Leistungsquelle und der einstellbaren Last besteht. In dieser Weise kann erreicht werden, dass eine maximal mögliche Leistung von der Leistungsquelle an die Last geliefert wird. So kann nämlich sicher eine geeignete Einstellung der Last erreicht werden, so dass die Lastimpedanz der Last einen im Vergleich zu der Quellenimpedanz der Leistungsquelle komplex konjugierte Wert annimmt bzw. dass die Lastimpedanz im Falle einer im Wesentlichen reellwertigen Quellenimpedanz der Leistungsquelle gleich der Quellenimpedanz der Leistungsquelle ist. Dadurch wird erreicht, dass die von der Leistungsquelle verfügbare Leistung im Rahmen unvermeidbarer Toleranzen bestmöglich an die Last abgegeben wird.

Ein weiteres Ausführungsbeispiel gemäß der vorliegenden Erfindung schafft eine Leistungsversorgungsanordnung mit einem elektrischen Generator, der ausgelegt ist, um als elektrische Leistungsquelle zu wirken, und um eine von dem Antriebszustand abhängige Leerlaufspannung bereitzustellen. Der elektrische Generator weist eine Quellenimpedanz bzw. einen Innenwiderstand auf, so dass in einem Belastungsfall eine Klemmenspannung des elektrischen Generators kleiner als die Leerlaufspannung des elektrischen Generators ist. Die Leistungsversorgungsanordnung umfasst im Übrigen die oben beschriebene Lastanordnung, wobei der Belastungszustandsbestimmer der Lastanordnung ausgelegt ist, um basierend auf der Erfassung eines von dem elektrischen Generator an die einstellbare Lastschaltung gelieferten Momentanstroms die elektrische Größe, die einen Spannungsabfall an der Quellenimpedanz der Leistungsquelle beschreibt, so zu liefern, dass diese einen Spannungsabfall an der Quellenimpedanz des elektrischen Generators beschreibt.

Ein weiteres Ausführungsbeispiel gemäß der Erfindung schafft ein Verfahren zum Bestimmen eines Belastungszustandes einer elektrischen Leistungsquelle, die eine Quellenimpedanz, zum Beispiel einen Innenwiderstand, umfasst. Das Verfahren umfasst ein Bestimmen einer Größe, die einen Spannungsabfall an einem Innenwiderstand der Leistungsquelle beschreibt, basierend auf einer Erfassung eines unter Last von der Leistungsquelle an die Last gelieferten Momentanstroms. Das Verfahren umfasst ferner ein Erhalten eines Informationssignals, das eine Information über eine momentane Relation zwischen der Klemmenspannung der Leistungsquelle und der Leerlaufspannung der Leistungsquelle trägt, basierend auf der Größe, die den Spannungsabfall an der Quellenimpedanz der Leistungsquelle beschreibt, und einer elektrischen Größe, die die Klemmenspannung der Leistungsquelle beschreibt.

Das entsprechende Verfahren bringt die gleichen Vorteile und Wirkungen wie sie oben im Hinblick auf die erfindungsgemäße Vorrichtung beschrieben wurden.

### Figurenkurzbeschreibung

- Fig. 1: zeigt eine schematische Darstellung eines Belastungszustandsbestimmers gemäß einem ersten Ausführungsbeispiel der vorliegenden Erfindung;
- Fig. 2: zeigt eine schematische Darstellung einer Leistungsversorgungsanordnung, gemäß einem zweiten Ausführungsbeispiel der vorliegenden Erfindung;
- Fig. 3: zeigt ein Blockschaltbild einer Leistungsversorgungsanordnung gemäß einem dritten Ausführungsbeispiel der vorliegenden Erfindung;
- Fig. 4: zeigt ein detailliertes Schaltbild eines Belastungszustandsbestimmers gemäß einem vierten Ausführungsbeispiel der vorliegenden Erfindung;
- Fig. 5: zeigt ein detailliertes Schaltbild eines Belastungszustandsbestimmers gemäß einem fünften Ausführungsbeispiel der vorliegenden Erfindung;
- Fig. 6: zeigt ein detailliertes Schaltbild eines Belastungszustandsbestimmers gemäß einem sechsten Ausführungsbeispiel der vorliegenden Erfindung;
- Fig. 7: zeigt detailliertes Schaltbild eines Belastungszustandsbestimmers gemäß einem siebten Ausführungsbeispiel der vorliegenden Erfindung; und
- Fig. 8: zeigt ein Flussdiagramm eines Verfahrens zum Bestimmen eines Belastungszustandes, gemäß einem achten Ausführungsbeispiels der vorliegenden Erfindung.

### Detaillierte Beschreibung der Ausführunsgbeispiele

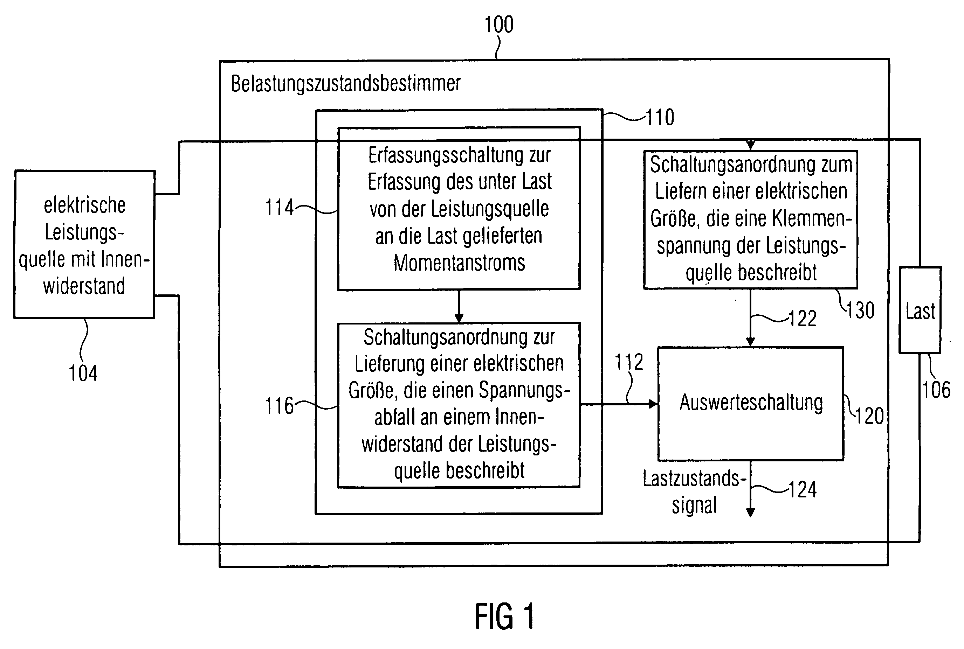

### Ausführungsbeispiel gemäß der Figur 1

Fig. 1 zeigt ein Blockschaltbild eines Belastungszustandsbestimmers gemäß einem ersten Ausführungsbeispiel der vorliegenden Erfindung. Der Belastungszustandsbestimmer 100 ist ausgelegt, um einen Belastungszustand einer elektrischen Leistungsquelle 104, die typischerweise nicht Teil des Belastungszustandsbestimmers 100 ist, zu bestimmen. Dabei wird davon ausgegangen, dass die elektrische Leistungsquelle 104 einen Innenwiderstand bzw., allgemeiner, eine Quellenimpedanz aufweist, die dem Belastungszustandsbestimmer 100 zumindest näherungsweise bekannt ist oder bei manchen Ausführungsbeispielen auch von diesem ermittelt wird.

Der Belastungszustandsbestimmer 100 umfasst eine Spannungsabfall-Bestimmungsschaltung 110, die ausgelegt ist, um basierend auf einer Erfassung eines unter Last von der Leistungsquelle 104 an eine Last 106, die typischerweise nicht Teil des Belastungszustandsbestimmers 100 ist, gelieferten Momentanstroms eine elektrische Größe 112 zu liefern, die einen Spannungsabfall an einem Innenwiderstand der Leistungsquelle 104 beschreibt. Der Belastungszustandsbestimmer 100 umfasst ferner eine Auswerteschaltung 120, die ausgelegt ist, um basierend auf der elektrischen Größe 112, die den Spannungsabfall an dem Innenwiderstand der Leistungsquelle 104 beschreibt, und einer elektrischen Größe 122, die eine Klemmenspannung der Leistungsquelle beschreibt, ein Lastzustand-Signal 124 zu erhalten, das eine Information über die momentane Relation zwischen der Klemmenspannung der Leistungsquelle und einer Leerlaufspannung der Leistungsquelle trägt.

Somit ist der Belastungszustandsbestimmer 100 insgesamt ausgelegt, um basierend auf einer Messung eines Momentanwerts des von der Leistungsquelle 104 an die Last 106 gelieferten Stroms und eines Momentanwerts der Klemmenspannung das Lastzustandssignal derart zu erhalten, dass dieses die momentane Relation zwischen der Klemmenspannung der Leistungsquelle und der Leerlaufspannung der Leistungsquelle beschreibt.

Die Spannungsabfall-Bestimmungsschaltung 110 kann beispielsweise eine Erfassungsschaltung 114 zur Erfassung des (unter Last) von der Leistungsquelle 104 an die Last 106 gelieferten Momentanstroms und eine Schaltungsanordnung 116 zum Liefern der elektrischen Größe 112, die den Spannungsabfall an einem Innenwiderstand der Leistungsquelle beschreibt, basierend auf dem erfassten Momentanstrom aufweisen. Außerdem kann der Belastungszustandsbestimmer 100 beispielsweise eine Schaltungsanordnung 130 zum Liefern der elektrischen Größe 122, die eine Klemmenspannung der Leistungsquelle beschreibt, umfassen. Die Schaltungsanordnung 130 kann somit ausgelegt sein, um die entsprechende Größe 122 an die Auswerteschaltung 120 zu liefern.

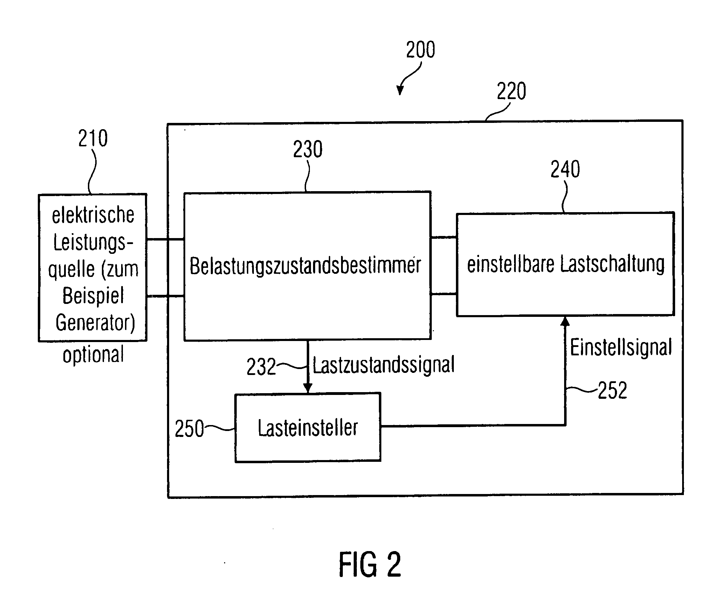

### Ausführunsgbeispiel gemäß Figur 2

Fig. 2 zeigt ein Blockschaltbild einer Leistungsversorgungsschaltung gemäß einem zweiten Ausführungsbeispiel der vorliegenden Erfindung. Die Leistungsversorgungsschaltung 200 gemäß der Fig. 2 umfasst eine elektrische Leistungsquelle 210, bei der es sich beispielsweise um einen elektrischen Generator handeln kann, und die der elektrischen Leistungsquelle 104 entsprechen kann. Die Leistungsversorgungsschaltung 200 umfasst ferner eine Lastanordnung 220. Die Lastanordnung 220 umfasst einen Belastungszustandsbestimmer 230, der beispielsweise gleich dem oben beschriebenen Belastungszustandsbestimmer 100 sein kann. Die Lastanordnung 200 umfasst ferner eine einstellbare Lastschaltung 240, die beispielsweise der Last 106 entsprechen kann. Die Lastanordnung 220 umfasst ferner einen Lasteinsteller 250.

Der Belastungszustandsbestimmer 230 ist dabei zwischen die elektrische Leistungsquelle 210 und die einstellbare Lastschaltung 240 geschaltet, um den von der elektrischen Leistungsquelle an die einstellbare Lastschaltung 240 gelieferten Momentanstrom zu erfassen, wie dies schon anhand der Fig. 1 erläutert wurde. Die einstellbare Lastschaltung 240 ist dabei in der Lage, eine gegenüber der elektrischen Leistungsquelle 210 präsentierte Impedanz zu verändern. Beispielsweise kann die einstellbare Lastschaltung 240 ausgelegt sein, um eine Eingangsimpedanz bzw. einen Eingangswiderstand in Abhängigkeit von einem Einstellsignal 252 zu verändern. Alternativ dazu kann die einstellbare Lastschaltung 240 ausgelegt sein, um eine mittlere Stromaufnahme (z.B. durch eine Induktivität) in Abhängigkeit von dem Einstellsignal 242 zu variieren.

Der Lasteinsteller 250 ist dabei in der Lage, die Last in Abhängigkeit von dem Lastzustand-Signal, das von dem Belastungszustandsbestimmer 230 geliefert wird, so einzustellen, dass eine Leistungsanpassung zwischen der Leistungsquelle 210 und der einstellbaren Lastschaltung 240 besteht.

Insgesamt kann somit der Belastungszustandsbestimmer 230 ermitteln, ob die Klemmenspannung der elektrischen Leistungsquelle 210 oberhalb oder unterhalb der halben Leerlaufspannung der elektrischen Leistungsquelle 210 liegt, bzw. ob die Klemmenspannung der elektrischen Leistungsquelle 210 zumindest näherungsweise (zum Beispiel mit einer Toleranz von +/-5% oder +/-10%) gleich einer Hälfte der Leerlaufspannung der elektrischen Leistungsquelle 210 ist. Diese Relation zwischen der Klemmenspannung der Leistungsquelle und der Leerlaufspannung der Leistungsquelle wird durch das Lastzustandssignal 232 angezeigt. Das Lastzustandssignal 232 gibt somit beispielsweise unmittelbar eine Information darüber, ob die einstellbare Lastschaltung 240 eine Impedanz gegenüber der elektrischen Leistungsquelle 210 darstellt, die größer als eine zur Erzielung einer Leistungsanpassung benötigte Impedanz, kleiner als eine zur Erzielung einer Leistungsanpassung benötigte Impedanz oder gleich einer zur Erzielung einer Leistungsanpassung benötigten Impedanz ist. Somit ist der Lasteinsteller 250 in der Lage, an die einstellbare Lastschaltung 240 ein entsprechendes Einstellsignal 252 auszugeben, das eine Veränderung der durch die einstellbare Lastschaltung 240 gegenüber der elektrischen Leistungsquelle dargestellten Impedanz bewirkt. Dadurch wird es ermöglicht, in Abhängigkeit von dem Lastzustandssignal 232 eine Regelung hin zu einem Zustand bestmöglicher (oder zumindest ausreichend guter) Leistungsanpassung zu erzielen.

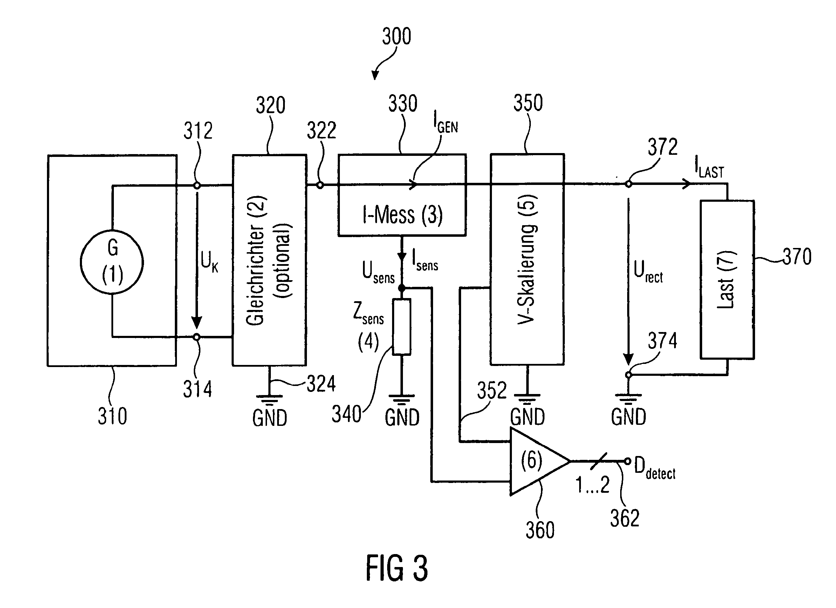

### Ausführungsbeispiel gemäß der Figur 3

Fig. 3 zeigt ein Blockschaltbild einer Leistungsversorgungsschaltung 300 gemäß einem weiteren Auskhrungsbeispiel der Erfindung.

Die Leistungsversorgungsschaltung 300 umfasst einen Generator 310, der einen Innenwiderstand bzw. eine Quellenimpedanz aufweist. Zwischen einem ersten Generatoranschluss 312 und einem zweiten Generatoranschluss 314 des Generators 310 ist eine Klemmenspannung U_{K} abgreifbar. Die Leistungsversorgungsschaltung 300 umfasst ferner einen Gleichrichter 320, der als optional anzusehen ist. Eingangsanschlüsse des Gleichrichters 320 sind mit den Klemmen bzw. Generatoranschlüssen 312, 314 des Generators 310 gekoppelt. Ein erster Ausgangsanschluss 322 des Gleichrichters 320 ist beispielsweise mit einem ersten Anschluss 372 einer Last 370 gekoppelt. Ein zweiter Ausgangsanschluss 324 des Gleichrichters 320 ist beispielsweise, aber nicht notwendigerweise, mit einem Bezugspotenzial GND gekoppelt, wobei ein zweiter Anschluss 374 der Last 370 ebenfalls mit dem Bezugspotential GND gekoppelt ist. Alternativ dazu kann der zweite Ausgangsanschluss 324 des Gleichrichters 320 aber auch anderweitig mit dem zweiten Anschluss 374 der Last 370 gekoppelt sein.

Die Leistungsversorgungsanordnung 300 umfasst im übrigen eine Strommessschaltung 330, die zumindest teilweise zwischen den Generator 310 und die Last 370 geschaltet ist, um den von dem Generator 310 an die Last 370 gelieferten Generatorstrom I_{gen} zu erfassen und ein Hilfs-Stromsignal Iₛₑₙₛ zu erzeugen, das den Generatorstrom I_{gen} beschreibt bzw. das bevorzugt proportional zu dem Generatorstrom I_{gen} ist Die Leistungsversorgungsanordnung 300 umfasst ferner einen Strom-Spannungs-Wandler 340, der ausgelegt ist, um das von der Strom-Mess-Schaltung 330 gelieferte Hilfs-Stromsignal Iₛₑₙₛ in eine Spannung Uₛₑₙₛ umzuwandeln, die die an der Quellenimpedanz des Generators 310 abfallende Spannung beschreibt. Der Strom-Spannungs-Wandler 340 kann dabei ein Impedanzbauteil umfassen, das beispielsweise an die Quellenimpedanz bzw. an den Innenwiderstand des Generators 310 angepasst sein kann. Die Leistungsversorgungsanordnung 300 umfasst ferner eine Spannungs-Skalierung 350, die ausgelegt ist, um ein Referenzsignal 352 zu erzeugen, welches proportional zur (optional gleichgerichteten) Klemmenspannung U_{K} des Generators 310 ist. Ferner umfasst die Leistungsversorgungsanordnung 300 auch noch einen Diskriminator bzw. Vergleicher 360, der ausgelegt ist, um die Spannung Uₛₑₙₛ, die den Spannungsabfall an der Quellenimpedanz bzw. an dem Innenwiderstand des Generators 310 beschreibt, und das Referenzsignal 352 zu empfangen und basierend darauf eine Diskriminator-Ausgangsinformation in Form von 1-2 Diskriminator-Ausgangssignalen zu liefern, wobei die Diskriminator-Ausgangssignale eine größenmäßige Relation (z.B. kleiner, zumindest näherungsweise gleich oder größer) zwischen der Spannung Uₛₑₙₛ und dem Referenzsignal 352 beschreiben.

Im Hinblick auf die Funktion der Leistungsversorgungsanordnung 300 ist festzuhalten, dass durch den Vergleich zwischen der Spannung Uₛₑₙₛ, die den Spannungsabfall über der Quellenimpedanz bzw. dem Innenwiderstand des Generators 310 beschreibt, und dem Referenzsignal 352, das die Klemmenspannung bzw. die gleichgerichtete Klemmenspannung des Generators 310 beschreibt (und bevorzugt proportional zu der gleichgerichteten Klemmenspannung ist), eine unmittelbare Aussage im Hinblick auf den Belastungszustand des Generators 310 getroffen werden kann. Diese Aussage im Hinblick auf den Belastungszustand gibt insbesondere eine Auskunft darüber, ob die Impedanz der Last 370 zu klein, zu groß, oder gerade passend ist, um eine Leistungsanpassung zwischen dem Generator 310 und der Last 370 zu erzielen. Da die Strommessung, also die Erfassung des Generatorstroms I_{gen}, und die Erfassung der gleichgerichteten Klemmenspannung U_{K} praktisch gleichzeitig, beispielsweise bei gleicher Last, erfolgen, kann bei den hierin beschriebenen Ausführungsbeispielen der Belastungszustand zeitlich kontinuierlich, also beispielsweise sogar zu einem einzigen Zeitpunkt, ermittelt werden.

Zusammenfassend ist somit festzuhalten, dass die Fig. 3 ein Blockschaltbild einer Spannungsversorgungsschaltung mit einem externen Generator 310, einem Gleichrichter 320, einer Strommessung 330, einem Strom-Spannungs-Wandler 340, einer Spannungs-Skalierung 350 zur Erzeugung eines Referenzsignals, welches proportional zur gleichgerichteten Klemmenspannung U_{K} ist, und einem Diskriminator 360, welcher je nach benötigter Ausprägung ein bis zwei Ausgangssignale bereitstellt, zeigt. Der Strom durch die Last 370 sollte dabei dem Ausgangsstrom des Generators 310 bzw. dem gemessenen Strom durch die Strommessanordnung 330 möglichst nahe kommen.

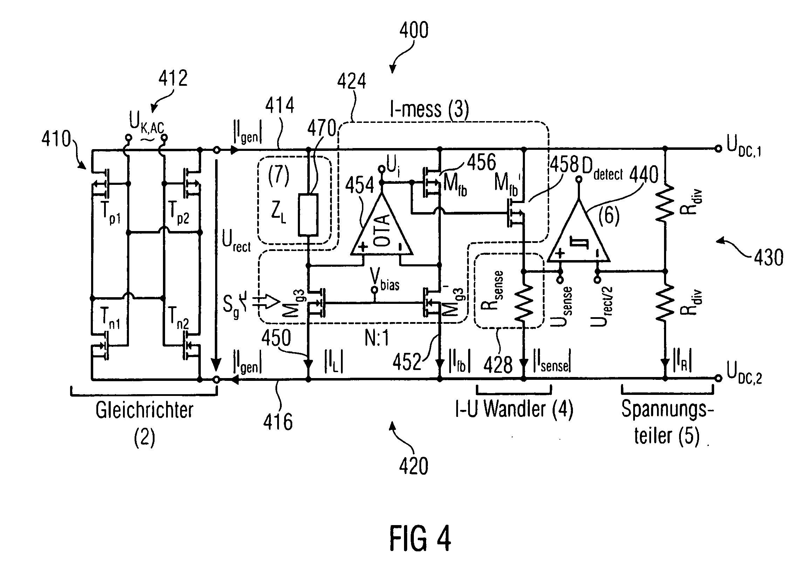

### Ausführungsbeispiel gemäß Figur 4

Fig. 4 zeigt ein detailliertes Schaltbild eines Belastungszustandsbestimmers, gemäß einem vierten Ausführungsbeispiel der Erfindung. Der Belastungszustandsbestimmer 400 umfasst einen optionalen Gleichrichter 410, der zwischen einen Wechselspannungseingang 412 des Belastungszustandsbestimmers und Gleichspannungsleitungen 414, 416 geschaltet ist. Der Belastungszustandsbestimmer 400 umfasst ferner eine Spannungsabfall-Bestimmungsschaltung 420, die ihrerseits eine Strom-Erfassungsschaltung 424 und einen Strom-Spannungs-Wandler 428 umfasst. Zudem umfasst die Leistungsversorgungsschaltung 400 einen Spannungsteiler 430, der zwischen die erste Gleichspannungsleitung 414 und die zweite Gleichspannungsleitung 416 geschaltet ist. Zudem umfasst der Belastungszustandsbestimmer 400 einen Vergleicher oder Diskriminator 440, der ausgelegt ist, um eine von dem Strom-Spannungs-Wandler 428 gelieferte Spannung Uₛₑₙₛ mit einer von dem Spannungsteiler 430 gelieferten Referenzspannung U_{rect/2} zu vergleichen und basierend darauf ein Lastzustand-Signal D_{detect} zu liefern.

In dem Belastungszustandsbestimmer 400 ist eine Laststrecke (zum Beispiel eine Drain-Source-Strecke, oder alternative eine Kollektor-Emitter-Strecke) eines Strom-Erfassungstransistors 450 in Serie mit einer Last 470 zwischen die erste Gleichspannungsleitung 414 und die zweite Gleichspannungsleitung 416 geschaltet. Somit fließt der Laststrom I_{L}, der zumindest bei aktivierter Last 470 einen wesentlichen bzw. weit überwiegenden Anteil (zum Beispiel über 90%, oder sogar über 98%) des von dem Generator gelieferten Generatorstroms I_{gen} ausmacht, durch die Laststrecke des Strom-Erfassungstransistors 450. Bei dem Strom-Erfassungstransistor 450 handelt es sich beispielsweise um einen n-Kanal-Feldeffekttransistor (oder, alternativ, um einen npn-Bipolartransistor). Die Strom-Erfassungsschaltung 424 umfasst im übrigen einen Spiegeltransistor 452, der von seiner qualitativen Struktur her (also beispielsweise im Hinblick auf den Transistortyp, die verwendeten Materialien und die Schichtenfolge) dem Strom-Erfassungstransistor 450 entspricht. Allerdings ist typischerweise eine Kanalbreite (oder alternativ eine Emitterfläche) des Strom-Erfassungstransistors um einen Faktor N größer als eine Kanalbereite (oder alternativ Emitterfläche) des Spiegeltransistors 452. Im übrigen sei darauf hingewiesen, dass Steueranschlüsse, z.B. Gate-Anschlüsse (oder alternativ Basisanschlüsse bei Verwendung von Bipolartransistoren), des Strom-Erfassungstransistors und des Spiegeltransistors 452 miteinander verbunden sind. Im übrigen sind sowohl ein Quellenanschluss (z.B. Source-Anschluss bzw. Emitteranschluss) des Strom-Erfassungstransistors 450 als auch ein Quellenanschluss (z.B. Source-Anschluss) des Spiegeltransistors 452 (beispielsweise unmittelbar) mit der zweiten Gleichspannungsleitung 416 verbunden. Somit wird erreicht, dass die Steuerspannungen (z.B. Gate-Source-Spannungen oder alternativ Basis-Emitter-Spannungen) des Strom-Erfassungstransistors 450 und des Spiegeltransistors 452 stets gleich groß sind. Zudem umfasst die Strom-Erfassungsschaltung 424 eine Regelschaltung, die ausgelegt ist, um zu erreichen, dass eine Laststrecken-Spannung (z.B. Drain-Source-Spannung) des Spiegeltransistors genauso groß ist wie eine Laststrecken-Spannung des Strom-Erfassungstransistors. Die Regelanordnung umfasst dabei beispielsweise einen Operationsverstärker 454 sowie einen ersten Strombank-Transistor 456. Eingänge (+,-) des Operationsverstärker 454 sind beispielsweise mit dem Drain-Anschluss des Strom-Erfassungstransistors 450 und dem Drain-Anschluss des Spiegeltransistors 452 verbunden. Eine Laststrecke (z.B. Drain-Source-Strecke) des ersten Strombank-Transistors 456 ist im übrigen in Serie zu der Laststrecke des Spiegeltransistors 452 zwischen die erste Gleichspannungsleitung 414 und die zweite Gleichspannungsleitung 416 geschaltet. Bei dem ersten Strombank-Transistor handelt es sich im übrigen beispielsweise um einen p-Kanal-Feldeffekt-Transistor. Ein Ausgang des Operationsverstärkers 454 ist im übrigen mit dem Steueranschluss, zum Beispiel Gate-Anschluss, des ersten Strombank-Transistors 456 verbunden. Somit wird erreicht, dass in einem Betrieb der Operationsverstärker 454 die Spannung an dem Gate-Anschluss des ersten Strombank-Transistors 456, und folglich den Stromfluss durch die Laststrecke des ersten Strombank-Transistors 456 so einstellt, dass die Drain-Source-Spannung über dem Spiegeltransistor 452 im Wesentlichen gleich groß wird wie die Drain-Source-Spannung über dem Strom-Erfassungstransistor 450.

Dabei wird im übrigen erreicht, dass sowohl die Eingangsspannung an den Eingängen (+, - ) des Operationsverstärkers 454 als auch die Ausgangsspannung Uᵢ des Operationsverstärkers 454 potenzialmäßig in einem Bereich zwischen dem an der ersten Gleichspannungsleitung 414 anliegenden Potenzial und dem an der zweiten Gleichspannungsleitung 416 anliegenden Potenzial liegt. Somit ist es möglich, die an den Gleichspannungsleitungen 414, 416 anliegenden Potenziale zur Versorgung des Operationsverstärkers 454 zu verwenden. Dies ist allerdings nicht zwingend erforderlich.

Im übrigen umfasst die Strom-Erfassungsschaltung einen zweiten Strombank-Transistor 458, der so verschaltet ist, dass dessen Steuerspannung (z.B. Gate-Source-Spannung) gleich der Steuerspannung des ersten Strombank-Transistors 456 ist. Somit wird, einen geeigneten Arbeitspunkt vorausgesetzt, erreicht, dass ein Laststreckenstrom des zweiten Strombank-Transistors 458 gleich einem Laststreckenstrom des ersten Strombank-Transistors 456 ist, oder dass der Laststreckenstrom des zweiten Strombank-Transistors 458 zumindest proportional zu dem Laststreckenstrom des ersten Strombank-Transistors 456 ist.

Insgesamt wird somit durch die Strom-Erfassungsschaltung 424 erreicht, dass der Laststreckenstrom des zweiten Strombank-Transistors 458, der dem Strom-Spannungs-Wandler 428 zugeführt wird, proportional zu dem Laststrom I_{L}, der durch die Last 470 fließt, ist.

Das Impedanzbauteil, das als Strom-Spannungs-Wandler 428 dient, ist bevorzugt in Serie zu der Laststrecke des zweiten Strombank-Transistors 458 zwischen die erste Gleichspannungsleitung 414 und die zweite Gleichspannungsleitung 416 geschaltet. Bei dem Impedanzbauteil Rₛₑₙₛ kann es sich beispielsweise um einen Widerstand handeln. Alternativ dazu kann aber auch ein anderes Impedanzbauteil, oder eine Kombination mehrerer Impedanzbauteile zum Einsatz kommen, um die Quellenimpedanz des Generators möglichst gut nachzubilden. Eine Impedanz des Impedanzbauteils (zum Beispiel Widerstands), das den Strom-Spannungs-Wandler 428 bildet, ist im Übrigen so gewählt, dass die durch den Strom-Spannungs-Wandler 428 erzeugte Spannung Uₛₑₙₛ ein Maß für einen Spannungsabfall an der Quellenimpedanz bzw. dem Innenwiderstand des in der Fig. 4 nicht gezeigten Generators ist. Beispielsweise kann durch eine geeignete Dimensionierung des Strom-Spannungs-Wandlers erreicht werden, dass die Spannung Uₛₑₙₛ halb so groß ist wie der Spannungsabfall an den Innenwiderstand des Generators bzw. der Leistungsquelle.

Der Spannungsteiler 430 kann beispielsweise so ausgelegt werden, dass die Spannung U_{rect/2} halb so groß ist wie die (gleichgerichtete) Klemmenspannung U_{K} der Leistungsquelle bzw. des Generators. Der Vergleicher bzw. Diskriminator 440 ist im Übrigen ausgelegt, um die an dem Strom-Spannungs-Wandler 428 anliegende Spannung Uₛₑₙₛ mit der an dem Abgriff des Spannungsteilers 430 anliegende Spannung U_{rect/2} (bzw. die entsprechenden Potentiale) zu vergleichen und als Lastzustands-Signal ein Signal zu liefern, das eine größenmäßige Relation (größer oder kleiner, oder ggf. annäherungsweise gleich) zwischen den Spannungen (bzw. Potentialen) Uₛₑₙₛ und U_{rect/2} beschreibt.

Im Hinblick auf die Funktionsweise der Schaltungsanordnungen 300 und 400, sowie auch der übrigen Schaltungsanordnungen, ist zusammenfassend festzuhalten, dass die vorliegende Erfindung davon ausgeht, dass die Quellenimpedanz (bzw. der Innenwiderstand) der Leistungsquelle bzw. des Generators bekannt ist, da diese typischerweise aus den Spezifikationen des Generators direkt hervorgeht. Zur leistungsarmen Detektierung wird daher ein dem momentanen Generatorstrom I_{gen} proportionaler Strom, z.B. der Strom Iₛₑₙₛ bzw. der Strom durch die Last 428 des zweiten Strombank-Transistors 458, mit hohem und bekanntem Teilungsfaktor N erzeugt. Dies erfolgt beispielsweise durch die zweifache Spiegelung des Stroms I_{L} unter Verwendung der Transistoren 450, 452, 456, 458 sowie des Operationsverstärkers 454, wobei der Teilungsfaktor beispielsweise durch unterschiedliche Kanalbreiten der Transistoren erzielt wird. Der zu dem momentanen Generatorstrom proportionale Strom, beispielsweise Iₛₑₙₛ, wird auf einen "Sensor"-Widerstand Rₛₑₙₛ (oder eine "Sensor"-Impedanz Zₛₑₙₛ) geleitet, wodurch sich eine Strom-Spannungs-Wandlung ergibt. Über dem "Sensor"-Widerstand Rₛₑₙₛ (oder über der Sensor-Impedanz Zₛₑₙₛ) ergibt sich damit eine Spannung Vₛₑₙₛ, die gelegentlich auch mit Uₛₑₙₛ bezeichnet ist (vgl. Fig. 4).

Der Wert des Sensor-Widerstandes bzw. Erfassungs-Widerstandes, also Zₛₑₙₛ, Rₛₑₙₛ ist dabei beispielsweise die Hälfte aus Generatorimpedanz x Teilungsfaktor N. Hat die Spannung Uₛₑₙₛ gerade den Wert der halben momentanen Klemmenspannung U_{K} bzw. U_{rect}, die beispielsweise durch die Spannungs-Skalierung 350 bzw. den Spannungsteiler 430 geliefert wird, so ist die Klemmenspannung gerade wiederum die Hälfte der Leerlaufspannung. Die Erzeugung der halben Klemmenspannung kann dabei beispielsweise einfach über einen hochohmigen Spannungsteiler, wie z.B. die Spannungs-Skalierung 350 bzw. den Spannungsteiler 430, erfolgen.

Die Schaltungsanordnung 400 kann in verschiedener Weise modifiziert werden. Ganz allgemein kann beispielsweise für bestimmte Zwecke ein alternatives Verhältnis abweichend von der halben Leerlaufspannung über die Wahl des Sensor-Widerstandes bzw. Erfassungswiderstandes Zₛₑₙₛ bzw. Rₛₑₙₛ, über die Wahl des Teilungsfaktors N und/oder über die Wahl des Spannungsteiler-Verhältnisses der Spannungs-Skalierung 350 bzw. des Spannungsteilers 430 eingestellt werden. Des Weiteren kann der Sensor-Widerstand bzw. Erfassungswiderstand Zₛₑₙₛ bzw. Rₛₑₙₛ durch eine komplexe Impedanz ersetzt werden, beispielsweise um auf bestimmte Generatoreigenschaften (beispielsweise im Hinblick auf die Quellimpedanz) zu reagieren.

Allerdings ist es bei einigen Ausführungsbeispielen bevorzugt, dass die Spannungs-Skalierung 350 bzw. der Spannungsteiler 430 an dem Abgriff die Hälfte der Klemmenspannung liefert. Der Grund, warum im konkreten Fall bevorzugt die Hälfte der Klemmenspannung herangezogen wird, besteht darin, dass die Klemmenspannung in einigen Fällen durchaus die höchste Spannung im System sein kann. Da im Bereich des Energie-Erntens oftmals auf eine externe Spannungsversorgung verzichtet werden soll, ist es daher technisch schwierig und leistungsintensiv, eine Spannung zu erzeugen, welche die Klemmenspannung des einzigen Generators (z.B. des Generators 310) dauerhaft übersteigt. Insofern wird eine einfache und kostengünstige Implementierung dadurch ermöglicht, dass die auftretenden Potenziale, insbesondere die Potenziale an den Eingängen des Vergleichers bzw. Diskriminator 440, zwischen einem unteren Versorgungspotenzial, das beispielsweise an der zweiten Gleichspannungsleitung 416 anliegt, und einem oberen Versorgungspotenzial, das beispielsweise an der ersten Gleichspannungsleitung 414 anliegt, liegen.

Im Folgenden werden noch einige Details im Hinblick auf den Vergleicher bzw. Diskriminator 360, 440 beschrieben. Die Detektierung, ob die Klemmenspannung U_{K} bzw. U_{rect} kleiner, gleich oder größer als die halbe Leerlaufspannung ist, kann über die Komparatorschaltung 360, 440 (die auch als "Diskrimator" bezeichnet wird) erfolgen.

Handelt es sich dabei um einen einfachen Komparator, so kann dieser lediglich einen Größer-Kleiner-Zustand erkennen (bzw. lediglich unterscheiden, ob die Spannung Uₛₑₙₛ größer oder kleiner als die Spannung U_{rect/2}, bzw. die Spannung an dem Abgriff 352 der Spannungs-Skalierung 350 ist). In Verbindung mit einer optionalen Triggerlogik kann der Übergang vom Zustand kleiner Klemmenspannung U_{K} bzw. U_{rect} zum Zustand größerer Klemmenspannung erfasst werden. Der dann von einem einfachen Komparator ausgegebene Signalwechsel kann von dem Leistungswandler (der beispielsweise die Last 370 bilden kann bzw. dessen Eingang als die Last 470 wirken kann) genutzt werden, um eine kontinuierliche Lastanpassung durchzuführen.

In einigen Ausführungsbeispielen kann eine komplexere Komparatorschaltung bzw. Diskriminatorschaltung 360, 440 verwendet werden. Für eine solche komplexere Komparatorschaltung können zwei einfache Komparatoren zu einem Fensterkomparator zusammengeschaltet werden. Durch eine Logik verknüpft kann dem Leistungswandler (der die Last 370 bilden kann, bzw. dessen Eingang die Last 470 darstellen kann) signalisiert werden, ob die momentane Klemmenspannung U_{K} bzw. U_{rect} ähnlich groß ist wie die momentane Leerlaufspannung, also innerhalb des Fensterbereichs liegt, oder ob die momentane Klemmenspannung über oder unter dem Fensterbereich liegt. Es gibt dann drei Signalzustände, die dem Leistungswandler verfügbar sind.

Wird alternativ anstatt des Komparators 360, 440 ein linearer Differenz-Verstärker eingesetzt, so kann auch ein analoges Signal ausgegeben werden, welches ein Maß für das Erreichen des gewünschten Verhältnisses (hier: 0,5) von Klemmenspannung zu Leerlaufspannung repräsentiert.

Im Folgenden werden einige Details im Hinblick auf den Gleichrichter erläutert. Durch geeignete Gleichrichter 320, 410 kann beispielsweise sichergestellt werden, dass die Klemmenspannung U_{K} und die gleichgerichtete Klemmenspannung U_{rect}, welche letztlich vom Detektor herangezogen wird, sich kaum bzw. nicht signifikant unterscheiden. Details diesbezüglich können beispielsweise in den Veröffentlichungen C. Peters, D. Spreemann, M. Ortmanns, Y. Manoli, "A CMOS integrated voltage and power efficient AC/DC converter for energy harvesting applications", Journal of Micromechanics Micro engineering, JMM, 18 104005, Issue 10, Oct. 2008, G. Bawa, J. Uei-Ming, M. Ghovanloo, "High Efficiency Full-Wave Rectifier in Standard CMOS Technology", Proc. IEEE 50th Midwest Symposium on Circuits and Systems, MWSCAS, Montreal, Canada, pp. 81-84, 2007 und S. Guo, H. Lee, "An Efficiency-Enhanced CMOS Rectifier With Unbalanced-Biased Comparators for Transcutaneous-Powered High-Current Implants", IEEE Journal of Solid-State Circuits (JSSC), vol. 44 no. 6, pp. 1796-1804, Jun. 2009 entnommen werden.

Beispielsweise kann ein geschalteter Gleichrichter eingesetzt werden, bei dem ein Spannungsabfall im Vergleich zu herkömmlichen Dioden-Brückengleichrichtern verringert wird, indem Transistoren anstelle der Dioden verwendet werden. Ein entsprechender Gleichrichter ist in Fig. 4 bei Bezugszeichen 412 im Detail gezeigt.

Im Folgenden wird eine optionale Ergänzung der erfindungsgemäßen Belastungszustandsbestimmer erläutert, die eine besonders universelle Einsetzbarkeit der Belastungszustandsbestimmer unter vielen verschiedenen Betriebsbedingungen ermöglicht. Üblicherweise ist der Innenwiderstand vieler Generatoren konstant und von der Betriebsart unabhängig. Daher kann als Ergänzung eine einmalige automatische Abstimmung der Detektionsschaltung 360, 440 bzw. des Sensor-Widerstandes (bzw. Erfassungswiderstandes) Zₛₑₙₛ, Rₛₑₙₛ vorgenommen werden. Der Innenwiderstand des Generators, beispielsweise des Generators 310, wird beispielsweise automatisch bestimmt, indem ein bekannter Teststrom in den Generator eingespeist wird, und indem dann die Spannungsänderung gemessen wird. Über einen einstellbaren Sensor-Widerstand (bzw. Erfassungswiderstand) bzw. über einen einstellbaren Teilungsfaktor N der Stromerfassungsvorrichtung 330, 424 bzw. des Stromspiegels kann dann automatisch die Detektionsschaltung an einen anderen Generator mit abweichendem Innenwiderstand bzw. an andere Betriebsbedingungen angepasst werden. Alternativ kann auch das Skalierungsverhältnis der Spannungs-Skalierung 350 bzw. das Teilungsverhältnis des Spannungsteilers 430 angepasst werden.

Im Folgenden werden weitere optionale Details im Hinblick auf die Realisierung des Belastungszustandsbestimmers 400 erläutert. Wie bereits oben beschrieben, zeigt die Fig. 4 eine konkrete schaltungstechnische Umsetzung des Detektors. Sowohl für die Strom-Spannungs-Wandlung 340, die über den Erfassungswiderstand Rₛₑₙₛ erfolgt, als auch für die Spannungs-Skalierung 350, die durch die Widerstände R_{div} des Spannungsteilers 430 erfolgt, werden hier ohmsche Widerstände verwendet. Der Diskriminator 360 ist ein Komparator 440. Hier wurde bei der schaltungstechnischen Umsetzung als Last-Element 470 allgemein eine Impedanz vorgesehen.

Zudem kann - aufgrund des Symmetrie eines Gleichrichters - die Spannung U_{dc,1} oder die Spannung U_{dc,2} wahlweise das positive bzw. negative Gleichspannungspotenzial annehmen.

Im Folgenden wird auf einige Aspekte und mögliche Modifikationen der Schaltungsanordnung 400 hingewiesen:
- Die Spannung U_{K} ist bevorzugt die Ausgangsspannung eines Generators 310, und diese Ausgangsspannung kann eine Wechselspannung U_{K,AC} oder eine Gleichspannung U_{K,DC} sein.
- Liefert der Generator 310 eine Wechselspannung U_{K,AC}, so wird typischerweise ein Gleichrichter 320, 410 benötigt.
- Liefert der Generator 310 bereits eine Gleichspannung U_{K,DC}, so kann auf den Gleichrichter 320, 410 verzichtet werden.
- Die Gleichspannungspotenziale U_{DC,1} und U_{DC,2} können wahlweise als Referenzpotenzial bzw. Masse verwendet werden bzw. wahlweise das positive bzw. negative Gleichspannungspotenzial zur Versorgung der Last darstellen.
- Der Strom I_{L} ist der wesentliche Laststrom, und sollte dem Generator-Ausgangsstrom I_{gen} sehr nahe kommen oder sogar gleich dem Generator-Ausgangsstrom I_{gen} sein. Alle anderen Ströme sollten in der Summe wesentlich kleiner sein als I_{L} bzw. I_{gen}. Bevorzugt sollte I_{L} von I_{gen} um höchstens 10% abweichen.
- Das Detektionssignal D_{detect} kann optional einem Leistungswandler bzw. Spannungswandler zur Verfügung gestellt werden. Der Wandler selbst kann dann beispielsweise Teil der Last 370, 470 sein. Ist der Wandler nicht Teil der Last 370, 470, dient er nur zur Spannungsanpassung der (gleichgerichteten) Generatorspannung (U_{DC,1}, U_{DC,2}) an eine Applikation 370, 470. Der Wandler wird dann extern versorgt.
- Der Schalttransistor 450, der auch mit M_{g3} bzw. Sg bezeichnet ist, kann bei einigen Ausführungsbeispielen auch einfach als ein Ein/Aus-Schalter betrachtet werden.

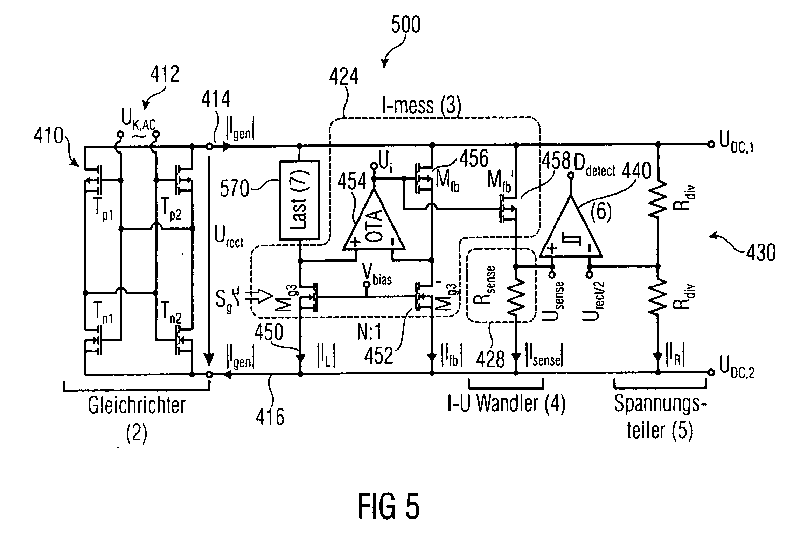

### Ausführungsbeispiel gemäß der Figur 5

Fig. 5 zeigt ein detailliertes Schaltbild eines Belastungszustandsbestimmers 500 gemäß einem fünften Ausführungsbeispiel der Erfindung. Fig. 5 zeigt dabei eine konkrete schaltungstechnische Umsetzung des Detektors mit einem allgemeinen elektrischen Verbraucher bzw. einer Last 570. Der allgemeine elektrische Verbraucher bzw. die Last 570 entspricht dabei der Last 370 gemäß der Fig. 3 bzw. der Last 470 gemäß der Fig. 4.

Da im Übrigen die Schaltungsanordnung 500 gemäß der Fig. 5 der Schaltungsanordnung 400 gemäß der Fig. 4 sehr ähnlich ist, sind gleiche Merkmale und Signale in den Schaltungsanordnungen 400 bzw. 500 mit gleichen Bezugszeichen versehen.

Die obigen Erläuterungen, auch im Hinblick auf mögliche optionale Erweiterungen und Modifikationen gelten entsprechend auch für die Schaltungsanordnung 500.

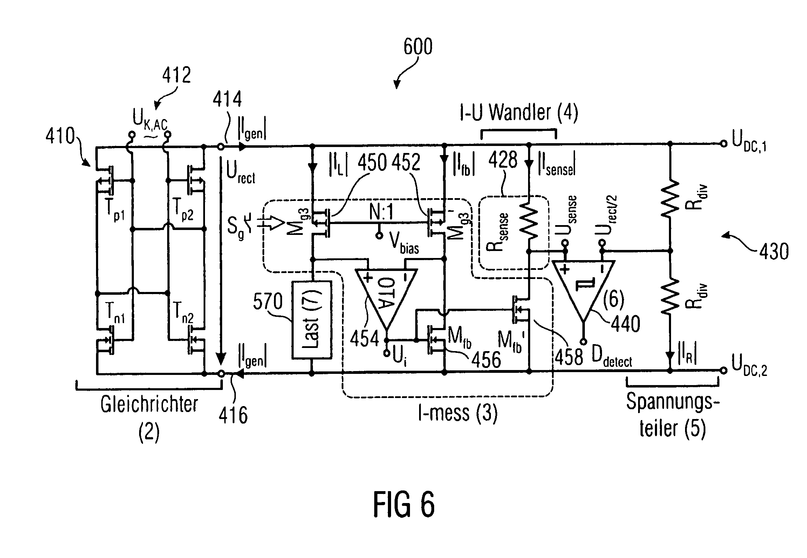

### Ausführungsbeispiel gemäß der Figur 6

Fig. 6 zeigt ein detailliertes Schaltbild eines Belastungszustandsbestimmers 600 gemäß einem sechsten Ausführungsbeispiel der Erfindung. Der Belastungszustandsbestimmer 600 gemäß der Fig. 6 ist im Wesentlichen komplementär zu dem Belastungszustandsbestimmer 500 gemäß der Fig. 5. In anderen Worten, Bauteile sind durch dazu komplementäre Bauteile ersetzt. Beispielsweise sind p-Kanal-Feldeffekttransistoren durch n-Kanal-Feldeffekttransistoren ersetzt. Ebenso sind n-Kanal-Feldeffekttransistoren durch p-Kanal-Feldeffekttransistoren ersetzt.

Abgesehen von der komplementären Ausführung der Bauteile gelten die oben im Hinblick auf die Schaltungsanordnungen gemäß den Fig. 3, 4 und 5 gemachten Ausführungen entsprechend.

Zusammenfassend ist somit festzuhalten, dass die Fig. 6 eine gespiegelte schaltungstechnische Umsetzung des Detektors zeigt, wobei die Last 570 zwischen dem Schalttransistor 450 und der Gleichspannungsleitung, die das Potenzial U_{DC,2} führt, platziert ist.

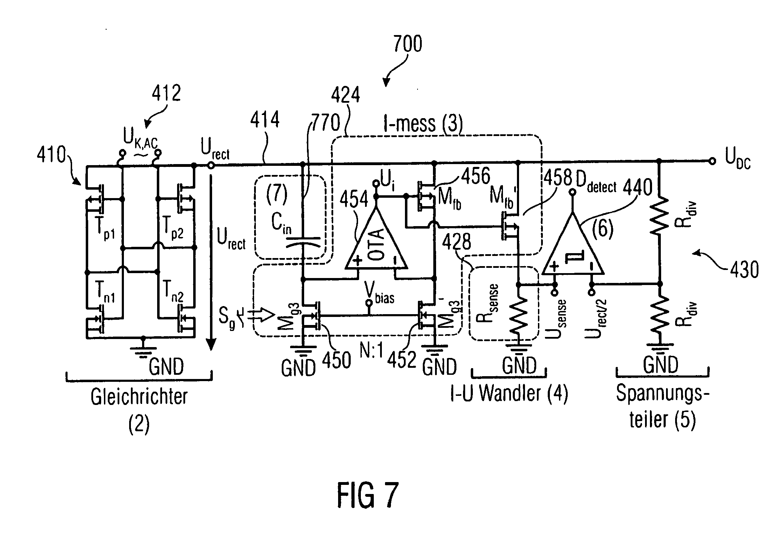

### Ausführungsbeispiel gemäß der Figur 7

Fig. 7 zeigt ein detailliertes Schaltbild eines Belastungszustandsbestimmers, gemäß einem siebten Ausführungsbeispiel der Erfindung. Der Belastungszustandsbestimmer 700 ist dem Belastungszustandsbestimmer 400 gemäß der Fig. 4 und auch dem Belastungszustandsbestimmer 500, 600 gemäß den Fig. 5 und 6 sehr ähnlich, so dass hier gleiche Einrichtungen und Signale mit gleichen Bezugszeichen bezeichnet sind.

Der Belastungszustandsbestimmer 700 unterscheidet sich von den Belastungszustandsbestimmern 400, 500 im Wesentlichen dadurch, dass die Last 470 bzw. die Last 570 durch einen Kondensator 770 ersetzt ist.

Im Übrigen ist die zweite Gleichspannungsleitung 416 durch eine Bezugspotenzialverbindung, die die Bezugspotenzialpunkte GND verbindet, ersetzt.

Zusammenfassend ist somit festzuhalten, dass die Fig. 7 eine konkrete schaltungstechnische Umsetzung des Detektors mit einem Kondensator 770 als Last 370, 470, 570 zeigt.

### Übersicht über das erfindungsgemäße Lösungskonzept gemäß den obigen Ausführungsbeispielen

Die oben beschriebenen Ausführungsbeispiele der Erfindung bringen erhebliche Verbesserungen beim Betrieb eines Leistungswandlers mit sich. Damit ein Leistungswandler, welcher an einen Energie-erntenden Generator (auch als "energy-harvesting generator" bezeichnet) angeschlossen ist, die maximal mögliche Generatorleistung zur Verfügung hat, sollte dieser Leistungswandler derart den Generator belasten, dass dessen Klemmenspannung seiner halben Leerlaufspannung entspricht. Die hier vorgestellte Erfindung ermöglicht es, im belasteten Betrieb genau zu erkennen, ob dies der Fall ist, bzw. liefert eine Größe für das Maß der Abweichung. Darüber hinaus kann die Schaltung bzw. das Detektionsprinzip feststellen, ob die Klemmenspannung größer oder kleiner als diese optimale halbe Leerlaufspannung ist.

Die Erfindung kann einem an dem Generator angeschlossenen Leistungswandler quasi kontinuierlich und verzögerungsfrei signalisieren, inwieweit sich die Klemmenspannung an ein bestimmtes Verhältnis (z.B. eben die Hälfte) der momentanen Leerlaufspannung angenähert hat. Dieses Signal bzw. diese Information kann dann dazu verwendet werden, um einem Leistungswandler zu signalisieren, inwieweit dessen Betriebsparameter (z.B. dessen Eingangsimpedanz) angepasst werden sollte, bzw. ob der optimale Betrieb erreicht ist. Dadurch, dass auch signalisiert werden kann, ob die Klemmenspannung über oder unterhalb der momentanen halben Leerlaufspannung ist, benötigt der Regler weniger komplexe Optimierungsalgorithmen, und das bereitgestellte Signal kann direkt als Indikator für einen Last-angepassten Betrieb dienen.

Im konkreten Fall wird signalisiert, ob die halbe momentane Leerlaufspannung an den Klemmen des Generators anliegt, oder ob diese gerade unterschritten oder überschritten ist.

Das Problem ist daher allgemein, während der Belastung des Generators zu erkennen, wann der optimale Lastfall (d.h. eine Lastanpassung dahingehend, dass die Lastimpedanz den Wert der komplex konjugierten Quellenimpedanz aufweist) bzw. die damit verbundene halbe Leerlaufspannung erreicht ist. Diese Aufgabe wird durch die anhand der Fig. 1 bis 7 beschriebenen Belastungszustandsbestimmer gelöst.

Die hierin beschriebenen Belastungszustandsbestimmer bieten ganz wesentliche Vorteile gegenüber konventionellen Lösungen. So ist die Detektierung während des Betriebs, also während der Belastung des Generators, möglich.

Mit nur einem einstellbaren Parameter (Rₛₑₙₛ) kann die Schaltung dem (in machen Ausführungsbeispielen notwendigen) Leistungs- bzw. Spannungswandler kontinuierlich und mit geringem Aufwand eine optimale Generatorbelastung signalisieren bzw. dem Wandler anzeigen, in welche Richtung er die Generatorbelastung verändern sollte.

Der Generatorstrom wird bevorzugt direkt in eine Vergleichsspannung (z.B. Vₛₑₙₛ) umgesetzt, welche mit einem Proportionalwert (hier: Proportionalitätsfaktor 0,5) der tatsächlichen Klemmenspannung verglichen wird. Über einen einfachen Komparator (auch als "Diskriminator" bezeichnet) lässt sich auf einfache Art und Weise das benötigte Signal erzeugen, das beispielsweise den Belastungszustand anzeigt.

Die einfache schaltungstechnische Umsetzung, die beispielsweise im Detail anhand der Fig. 3 bis 7 erläutert wurde, ermöglicht eine sehr leistungsarme Ermittlung der beschriebenen Ausgangssignale (beispielsweise des Signals D_{detect}). Bei Ausführungsbeispielen gemäß der Erfindung ist kein Analog-Digital-Wandler, kein Mikroprozessor und auch keine externe Referenzgröße notwendig.

Bei einigen Ausführungsbeispielen, z.B. bei den Ausführungsbeispielen gemäß den Fig. 4, 5, 6 und 7, werden durch die Kombination der Strommessung mit einem Leistungsschalter (z.B. dem in der Fig. 4 gezeigten Leistungsschalter S_{g}) keine zusätzlichen Serienverluste im Leistungspfad (U_{rect}) verursacht.

Im Folgenden werden einige der wesentlichen Vorteile, die sich für einen Anwender durch die vorliegende Erfindung ergeben, kurz zusammengefasst.

Durch die externe Sensorimpedanz bzw. den Widerstand Rₛₑₙₛ bzw. Zₛₑₙₛ des Strom-Spannungs-Wandlers kann der Benutzer den erfindungsgemäßen Detektor (bzw. Belastungszustandsbestimmer) einfach auf verschiedene Generatoren anpassen. Der typischerweise geringe Leistungsverbrauch des gesamten Detektors (typischerweise wenige Mikrowatt) belastet das Leistungsbudget eines typischen Energie-Erntenden-Systems (teilweise auch kurz als "harvesting-system" bezeichnet) nur geringfügig. Jedoch bringt die Erkenntnis über eine optimale Belastung - welche dieser Detektor ermöglich - meist einen signifikanten Gewinn an Generatorleistung. Somit wird die Gesamt-Leistungsbilanz, beispielsweise eines Energie-erntenden Systems, bei Einsatz des erfindungsgemäßen Detektors bzw. Belastungszustandsbestimmers verbessert. Ein Leistungswandler benötigt somit keinen aufwendigen Algorithmus oder Annahmen mehr, um den optimalen Lastfall zu ermitteln. Das heißt, die Reglerauslegung (das "Reglerdesign") für den oder die Leistungswandler kann einfach gestaltet werden. Somit reduziert sich deren interner Leistungsverbrauch, deren Platzbedarf und deren Entwicklungszeit.

Der geringe Verbrauch des Detektors ist mit den meist begrenzten Leistungsbudgets von typischen Energie-erntenden Systemen gut vereinbar. Daher wird die Anwendung eines Last-angepassten Generatorbetriebs in vielen Fällen überhaut erst möglich. Hierdurch kann ein Generator eher im optimalen Arbeitspunkt betrieben werden als bei herkömmlichen Anordnungen, wodurch seine Ausgangsleistung höher ist. Dies ermöglicht einerseits den Betrieb einer komplexeren und intelligenteren Anwenderelektronik bei gleichem Generator, d.h. es ergibt sich bei manchen Anwendungen ein Zugewinn an Funktionalität. Ist die bei solchen Anwendungen bereits erreichte Funktionalität ausreichend, so kann ein kleinerer Generator verwendet werden, da dieser nun im angepassten Betrieb arbeiten kann und somit hinreichend Leistung bereitstellt.

### Anwendungsgebiete

Zusammenfassend ist somit festzuhalten, das der Einsatz von Ausführungsbeispielen gemäß der vorliegenden Erfindung in vielen Fällen zu einer verbesserten Einsetzbarkeit von Energie-erntenden Systemen führt. Nicht zuletzt hilft die vorliegende Erfindung, Mikrogeneratoren effizienter einzusetzen und somit Energie-autarke Geräte am Markt verfügbarer bzw. leichter (oder billiger) verfügbar zu machen. Durch Energie-autarken Betrieb werden insbesondere Wartungs- und Instandhaltungsarbeiten reduziert oder teilweise sogar ganz eingespart. Die Zuverlässigkeit der Gesamtanlage (die einen Energie-Erntendes System enthält) wird erheblich erhöht, da häufige Beschädigungen der Kabelzuführung oder eine Selbstentladung von galvanischen Zellen ausbleiben werden. Gerade im Maschinenbau stellen Kabelzuführungen, welche oft sowohl ständiger mechanischer Knick- und Zugbelastung als auch chemischer Belastung (Kühlmittel und Dämpfe) ausgesetzt sind, mit die häufigste Ausfallursache einer Anlage dar. Auch seitens der Automobilindustrie werden Konzepte des autarken Betreibens von entlegenen Sensorikbaugruppen zur Einsparung von gewichtssteigernder und somit Kraftstoff-verbrauchender Verkabelung in Erwägung gezogen. Zudem werden gerade in der Sensorik neue Anwendungsfelder erschlossen werden können. In Einsatzbereichen, in denen mit herkömmlicher drahtgebundener Technik kaum eine Realisierung möglich ist bzw. sehr aufwändig wäre, kann nun (unter Verwendung der vorliegenden Erfindung) ein Energie-autarker Sensorknoten installiert werden. Beispiele hierfür sind die Gebäudetechnik, industrielle Hochtemperaturanlagen oder aber entlegene kalte Einsatzgebiete, wo galvanische Zellen oftmals den Betrieb versagen. Generell tritt mit der Einsparung von galvanischen Zellen auch ein ökologischer Aspekt bzw. Vorteil auf, da in den Energie-autarken Systemen mit Mikrogeneratoren keine solchen Energieträger mehr eingesetzt werden brauchen. Somit ist zusammenfassend festzuhalten, dass die Erfindung sehr gut geeignet ist für den Einsatz in Verbindung mit Energie-autarken Systemen, an denen derzeit ein großer Bedarf besteht.

Ausführungsbeispiele gemäß der Erfindung können somit in Energie-autarken Systemen, beispielsweise im Automobilbereich, in der Halbleitersparte, in der Reifendrucksensorik und in der Industrie- und Gebäudetechnik eingesetzt werden.

Im Hinblick auf die Einsatzgebiete der Erfindung ist somit anzumerken, dass insbesondere die Gebäudeüberwachung und Gebäudesteuerungen, der Anlagenbau bzw. Maschinenbau und nicht zuletzt die Automobilindustrie bereits heute nach Miniatur-Generatoren zur autarken Stromversorgung (auch als Energie-Ernten bzw. "Energy-Harvesting" bezeichnet) verlangen. In allen drei Bereichen können weitreichende Anwendungs- und Produktinnovationen zu nachhaltigem Erfolg am Absatzmarkt führen.

Die Energieversorgung von tragbaren elektronischen Systemen (z. B. für sog. "allgegenwärtigen Computerbetrieb" bzw. "Ubiquitous Computing"), Sensorsystemen (z. B: in Werkzeugmaschinen, Wohnungen oder als medizinische Implantate) und autonomen mikroelektronischen Systemen (z. B. Digitalsignalprozessoren mit geringer Leistungsaufnahme) erweist sich zunehmend als limitierender Faktor bei der Anwendung, Nutzung und weiteren Verbreitung solcher Systeme. Noch immer werden Primär- oder Sekundärbatterien für die genannten Ansätze verwendet. Neben Gewicht und Baugröße sind die begrenzte Lebensdauer, die geringe Zuverlässigkeit und der häufig schwierige oder gar unmögliche Austausch wesentliche Nachteile bei deren Nutzung. Zusätzlich sind Umweltbelastungen bei der Entsorgung zu beachten. Verfügbare Energie-Erntende-Systeme ("Harvesting-Systeme") haben meist das Problem, dass entweder ein großer Generator notwendig wäre, oder die Anwendung oft nur unzureichend funktioniert, da die Leistungsentnahme aus dem Generator sehr ineffizient abläuft. Trotz dieser Nachteile ist eine Steigerung der Nachfrage z. B. bei Sekundärbatterien von heute rund 8 Mrd. Stck. pro Jahr auf mehr als 10 Mrd. Stck. pro Jahr zu erwarten. Aufgrund der Nachteile bei Batterien einerseits und aufgrund der steigenden Bedeutung autarker/autonomer Systeme andererseits sind alternative Ansätze zur Energieversorgung von großer Bedeutung. Hierbei wäre selbst bei Substitution eines nur kleinen Anteils des Batteriemarktes in der Zukunft ein erhebliches Marktvolumen möglich. Aber nicht nur die Chancen auf teilweise Substitution des Batteriemarktes alleine zeigen die Marktchancen solcher Energie-erntenden Systeme bzw. Energie-autarken Systeme. Auch die sich neu ergebenen Anwendungsfelder von Sensorik und Elektronik werden eine erhöhte Nachfrage und gesteigerte Absatzmöglichkeit mit sich bringen.

Das erfindungsgemäße Konzept, in sehr effizienter Weise den Belastungszustand einer Energiequelle bestimmen zu können, ermöglicht dabei, den Wirkungsgrad bei der Ausnutzung der verfügbaren Generatorleistung zu erhöhen und verbessert somit das Kosten-/Nutzen-Verhältnis bei Energie erntenden Systemen.

### Weitere Vorteile im Vergleich zu herkömmlichen Konzepten

Ausführungsbeispiele gemäß der Erfindung schaffen es, die Nachteile der herkömmlichen Lösungen zu überwinden. Insbesondere kann keine der bekannten Methoden während des Betriebs (also während der Belastung) aus der Klemmenspannung (einer Energiequelle oder eines Generators) die Leerlaufspannung bzw. eine dazu proportionale Größe ermitteln. Die wird durch Ausführungsbeispiele der Erfindung ermöglicht.

Das Messen der Spannung, ob in gewissen Pausen oder kontinuierlich, wie es herkömmlicherweise verwendet wird, benötigt entweder eine Digitalisierung oder eine analoge Speicherung des Messwerts. Beides benötigt Prozessierungsleistung zur hinreichend genauen Darstellung des Wertes der Klemmenspannung bzw. kann zeitliche Änderung erfahren - beispielsweise durch Leckströme. Zudem muss bei derartigen herkömmlichen Konzepten gewährleistet sein, dass sich die Betriebsbedingungen, also die Generatorleistung und Generatorspannung, beispielsweise zwischen einem belasteten und einem unbelasteten Zustand nicht wesentlich ändert. Gerade beim Ernten von Energie ("Energy Harvesting"), bei dem geringe Leistungen typisch sind und Schwankungen der Generatorleistung oft beobachtet werden, ist diese Anforderung sehr nachteilig bzw. schwer zu erfüllen. Erfindungsgemäß hingegen wird eine Aussage darüber, ob die Klemmenspannung der halben Leerlaufspannung entspricht bzw. oberhalb oder unterhalb davon liegt, während einer Belastung der Leistungsquelle ermittelt.

Wird herkömmlicherweise mit bestimmten Test-Belastungen gemessen, so bedarf dies einer komplexeren Steuer- und Auswerteschaltung. Der zu generierende Teststrom muss mit hinreichender Präzision bereitgestellt werden, und die Messdaten müssen genau erfasst werden sowie anschließend prozessiert und gespeichert werden. Auch hier ist eine Änderung der Generatorleistung bzw. Spannung ein ergänzendes grundlegendes Problem. Erfindungsgemäß hingegen kann eine einfache Schaltung eingesetzt werden. Das erfindungsgemäße Konzept ermöglicht insbesondere die Ermittlung einer Information über einen Belastungszustand, die eine Relation zwischen der Klemmenspannung der Leistungsquelle und der Leerlaufspannung der Leistungsquelle beschreibt, unter Verwendung von Messgrößen, die in einem einzigen, gemeinsamen Lastzustand erhalten werden.

Die herkömmliche Verwendung eines parallel betriebenen unbelasteten Zusatzgenerators bringt das Risiko von Ungenauigkeiten und einer Fehlfunktion durch bauliche Schwankungen, Betriebseinflüsse oder durch Alterung abweichender Merkmale. Zudem ist diese Lösung platz- und kostenaufwändig und kann bei Fehlfunktion eine Betriebsstörung verursachen. Das erfindungsgemäße Konzept hingegen ist kostengünstig implementierbar und unterliegt vergleichsweise geringen Störeinflüssen.

Zusammenfassend ist somit festzuhalten, dass Ausführungsbeispiele gemäß der Erfindung das Problem lösen, während der Belastung eines Generators (bzw. allgemein einer Leistungsquelle) zu erkennen, wann ein optimaler Lastfall bzw. eine damit verbundene halbe Leerlaufspannung erreicht ist, wann also die Lastimpedanz den Wert der komplex konjugierten Quellenimpedanz (Impedanz des Generators) hat (was oft als "Impedanzanpassung" bezeichnet wird).

Zusammenfassend ist im Übrigen festzuhalten, dass die vorliegende Erfindung eine Elektronikschnittstelle für einen Energie-Ernter ("Energy Harvester") schafft. Die Elektronikschnittstelle, welche dem Generator die Leistung entnimmt und auf einem Puffer speichert, braucht eine Information über den Belastungszustand des Generators, da sonst der lastangepasste Betrieb nicht zufriedenstellend funktioniert und die Generatorleistung nicht maximal ist. Das erfindungsgemäße Konzept bzw. die erfindungsgemäße Schaltung kann auf einfache und leistungssparende Weise erkennen, ob der Generator im lastangepassten Betrieb läuft bzw. ob dieser über- oder unterbelastet wird. Das hierin beschriebene Schaltungsprinzip kann die oben genannte Information bereitstellen.

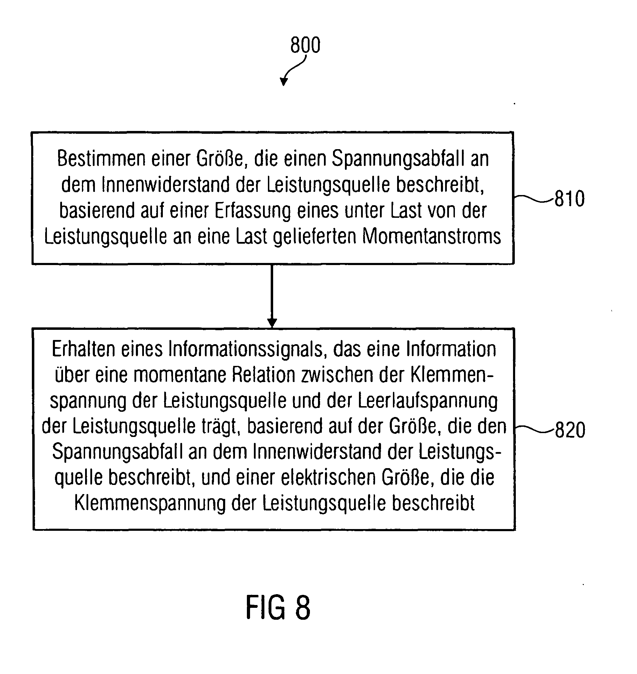

### Verfahren gemäß Fig. 8

Fig. 8 zeigt ein Flussdiagramm eines erfindungsgemäßen Verfahrens 800 zum Bestimmen eines Belastungszustands einer elektrischen Leistungsquelle, die eine Quellenimpedanz (zum Beispiel einen Innenwiderstand) aufweist.

Das Verfahren gemäß der Fig. 8 umfasst einen Schritt 810, indem eine Größe bestimmt wird, die den Spannungsabfall an der Quellenimpedanz (zum Beispiel dem Innenwiderstand) der Leistungsquelle beschreibt. Diese Größe wird basierend auf einer Erfassung eines unter Last von der Leistungsquelle an eine Last gelieferten Momentanstroms bestimmt.

Das Verfahren 800 umfasst ferner einen Schritt 820, in dem ein Informationssignal erhalten wird, das eine Information über eine momentane Relation zwischen der Klemmenspannung der Leistungsquelle und der Leerlaufspannung der Leistungsquelle trägt. Dieses Informationssignal wird basierend auf der Größe, die den Spannungsabfall an dem Innenwiderstand der Leistungsquelle beschreibt, und einer elektrischen Größe, die die Klemmenspannung der Leistungsquelle beschreibt, erhalten.

Das Verfahren 800 gemäß der Fig. 8 kann im Übrigen um all diejenigen Merkmale und Funktionalitäten ergänzt werden, die hierin auch im Hinblick auf die erfindungsgemäßen Vorrichtungen beschrieben wurden.

## Patentansprüche

1. Belastungszustandsbestimmer (100; 230; 450, 452, 454, 456, 458, 428, 430, 440) zum Bestimmen eines Belastungszustands einer elektrischen Leistungsquelle (104; 210;310), mit folgenden Merkmalen:
einer Spannungsabfall-Bestimmungsschaltung (110; 330, 340; 450, 452, 454, 456, 458, 428), die ausgelegt ist, um basierend auf einer Erfassung eines unter Last von der Leistungsquelle an eine Last (106; 240; 370; 470; 570; 770) gelieferten Momentanstroms (I_{L}) eine elektrische Größe (112; Uₛₑₙₛ) zu liefern, die einen Spannungsabfall an der Quellenimpedanz der Leistungsquelle beschreibt, und die zu dem Momentanstrom (I_{L}) proportional ist; und
einer Auswerteschaltung (120; 360; 440), die ausgelegt ist, um basierend auf der elektrischen Größe, die den Spannungsabfall an der Quellenimpedanz der Leistungsquelle beschreibt, und einer elektrischen Größe (122; 352; U_{rect/2}), die zu einer Klemmenspannung (U_{K}) der Leistungsquelle oder zu einer gleichgerichteten Klemmenspannung (Uₖ) der Leistungsquelle proportional ist, ein Lastzustandssignal (124; 232; D_{detect}) zu erhalten, das eine Information über eine momentane Relation zwischen der Klemmenspannung der Leistungsquelle und einer Leerlaufspannung der Leistungsquelle trägt, **dadurch gekennzeichnet, dass** die elektrische Leistungsquelle (104; 210; 310) eine bekannte Quellenimpedanz aufweist;
wobei die Auswerteschaltung (120; 360; 440) absgelegt ist, um zur Bestimmung der Information (124; 232; D_{detect}) über die Relation zwischen der Klemmspannung (U_{K}) der Leistungsquelle (104; 210; 310) und der Leerlaufspannung der Leistungsquelle die elektrische Größe (112; Uₛₑₙₛ), die den Spannungsabfall an der bekannten Quellenimpedanz der Leistungsquelle beschreibt, mit der elektrischen Größe (122; 352; U_{rect/2}), die zu der Klemmenspannung der Leistungsquelle oder zu der gleichgerichteten Klemmenspannung (Uₖ) der Leistungsquelle proportional ist, zu vergleichen;
wobei die Auswerteschaltung (120; 360; 440) ausgelegt ist, um das Lastzustandssignal so zu liefern, dass das Lastzustandssignal (124; 232; D_{detect}) anzeigt, ob die Klemmenspannung (U_{K}) der elektrischen Leistungsquelle zumindest näherungsweise gleich der Hälfte der Leerlaufspannung der elektrischen Leistungsquelle ist, oder sich von der Hälfte der Leerlaufspannung um mehr als eine vorbestimmte Toleranz unterscheidet, oder
wobei die Auswerteschaltung (120; 360; 440) ausgelegt ist, um das Lastzustandssignal (124; 232; D_{detect}) so zu liefern, dass das Lastzustandssignal anzeigt, ob die Klemmenspannung (U_{K}) größer oder kleiner als die Hälfte einer Leerlaufspannung der elektrischen Leistungsquelle (104; 210; 310) ist.

2. Belastungszustandsbestimmer (100; 230; 330, 340, 350, 360; 450, 452, 454, 456, 458, 428, 440, 430) gemäß Anspruch 1, wobei der Belastungszustandsbestimmer ausgelegt ist, um ein momentanes Lastzustandssignal (124; 232, D_{detect}) basierend auf einer Größe (Iₛₑₙₛ), die einen momentan an die Last (106; 240; 370; 470; 570; 770) gelieferten Momentanstroms (I_{L}) beschreibt, und der Größe der zur gleichen Zeit anliegenden momentanen Klemmenspannung (U_{K}) zu bestimmen.

3. Belastungszustandsbestimmer (100; 230; 320, 330, 340, 350; 450, 452, 454, 456, 458, 428, 440, 430) gemäß Anspruch 1 oder 2, wobei der Belastungszustandsbestimmer ausgelegt ist, um das momentane Lastzustandssignal (124; 232; D_{detect}) basierend auf einer Auswertung der Größe des momentan an die Last gelieferten Momentanstroms (I_{L}) und der Größe der momentanen Klemmspannung (U_{K}) in einem einzigen Lastzustand zu bestimmen.

4. Belastungszustandsbestimmer (100; 230; 330, 340, 350; 360; 450, 452, 454, 456, 458, 428, 440, 430) gemäß einem der Ansprüche 1 bis 3, wobei die Auswerteschaltung (120; 360; 440) ausgelegt ist, um zur Bestimmung der Information (124; 232; D_{detect}) über die Relation zwischen der Klemmspannung (U_{K}) der Leistungsquelle (104; 210; 310) und der Leerlaufspannung der Leistungsquelle die elektrische Größe (112; Uₛₑₙₛ), die den Spannungsabfall an der Quellenimpedanz der Leistungsquelle beschreibt, mit der elektrischen Größe (122; 352; U_{rect/2}), die die Klemmenspannung der Leistungsquelle beschreibt, zu vergleichen.

5. Belastungszustandsbestimmer (100; 230; 330, 340, 350; 360; 450, 452, 454, 456, 458, 428, 440, 430) gemäß einem der Ansprüche 1 bis 4, wobei die Spannungsabfall-Bestimmungsschaltung (110; 330, 340; 450, 452; 454, 456, 458, 428) ausgelegt ist, um einen zu dem an die Last gelieferten Momentanstrom (I_{L}) proportional Hilfsstrom (Iₛₑₙₛ) bereitzustellen;
wobei der Belastungszustandsbestimmer so ausgelegt ist, dass der an die Last gelieferte Momentanstrom (I_{L}) sich von einem von der Leistungsquelle (104; 210; 310) insgesamt gelieferten Strom (I_{gen}) um höchstens 10 % unterscheidet; und
wobei die Spannungsabfall-Bestimmungsschaltung ausgelegt ist, um basierend auf dem Hilfsstrom (Iₛₑₙₛ) und unter Verwendung eines reellwertigen oder komplexwertigen Impedanzbauteils, dessen Wert an die reellwertige oder komplexwertige Quellenimpedanz der Leistungsquelle (104; 110; 310) angepasst ist, eine Spannung (112; Uₛₑₙₛ) zu erzeugen, die den Spannungsabfall an der Quellenimpedanz der Leistungsquelle beschreibt; und
wobei die Auswerteschaltung (120; 360; 440) ausgelegt ist, um an einem Abgriff eines Spannungsteilers (130; 350; 430) eine zu der Klemmenspannung (U_{K}) proportionale Spannung (122; 352; U_{rect/2}) als die Größe, die die Klemmenspannung der Leistungsquelle beschreibt, zu empfangen; und
wobei die Auswerteschaltung einen Vergleicher oder Differenzverstärker (360; 440) aufweist, der ausgelegt ist, um die Spannung (112; Uₛₑₙₛ), die den Spannungsabfall an der Quellenimpedanz der Leistungsquelle beschreibt, und die Spannung (122; 352; U_{rect/2}), die an dem Abgriff des Spannungsteilers anliegt, als Eingangsspannungen zu empfangen.

6. Belastungszustandsbestimmer (100; 230; 330, 340, 350; 360; 450, 452, 454, 456, 458, 428, 440, 430) gemäß einem der Ansprüche 1 bis 5, wobei die Spannungsabfall-Bestimmungsschaltung (110; 330, 340; 450, 452, 454, 456, 458, 428) einen Last-Steuertransistor (450) aufweist, der ausgelegt ist, um einen Stromfluss durch die Last (106; 240; 370; 470; 570; 770) zu schalten oder zu regeln;
wobei die Spannungsabfall-Bestimmungsschaltung ausgelegt ist, um einen Spiegeltransistor (452), der von seiner qualitativen Struktur her dem Last-Steuertransistor (450) entspricht, an einen Arbeitspunkt zu bringen, der dem Arbeitspunkt des Last-Steuertransistors (450) entspricht; und
wobei die Spannungsabfall-Bestimmungsschaltung ausgelegt ist, um die Größe (112; Uₛₑₙₛ), die den Spannungsabfall an der Quellenimpedanz der Leistungsquelle beschreibt, basierend auf einem Stromfluss durch den Spiegeltransistor (452) oder basierend auf einem zu dem Stromfluss durch den Spiegeltransistor (452) proportionalen Stromfluss (Iₛₑₙₛ) zu bestimmen.

7. Belastungszustandsbestimmer gemäß Anspruch 6, wobei der Last-Steuertransistor (450) und der Spiegeltransistor (452) so geschaltet sind, dass eine Steuerspannung des Last-Steuertransistors (450) und des Spiegeltransistors (452) gleich sind, und
wobei die Spannungsabfall-Bestimmungsschaltung ausgelegt ist, um in die Laststrecke des Spiegeltransistors (452) unter Verwendung eines ersten Strombank-Transistors (456) einen Strom einzuprägen, und um den eingeprägten Strom so zu regeln, dass eine Laststrecken-Spannung des Spiegeltransistors (452), von einer Regelungenauigkeit abgesehen, gleich einer Laststreckenspannung des Last-Steuertransistors (450) ist; und
wobei die Spannungsabfall-Bestimmungsschaltung ausgelegt ist, um unter Verwendung eines zweiten Strombank-Transistors (458) einen zu dem von dem ersten Strombank-Transistor (456) gelieferten Strom proportionalen Strom bereitzustellen, und den von dem zweiten Strombank-Transistor (456) gelieferten Strom (Iₛₑₙₛ) in eine Spannung (Uₛₑₙₛ) zu wandeln, die den Spannungsabfall an der Quellenimpedanz der Leistungsquelle beschreibt.

8. Belastungszustandsbestimmer (100; 230; 330, 340, 350; 360) gemäß einem der Ansprüche 1 bis 7, wobei die Spannungsabfall-Bestimmungsschaltung (110; 330, 340) einen Quellenimpedanz-Bestimmer aufweist, der ausgelegt ist, um die Quellenimpedanz der Leistungsquelle zu bestimmen, und um die Bereitstellung der elektrischen Größe (112; Uₛₑₙₛ), die den Spannungsabfall an der Quellenimpedanz der Leistungsquelle beschreibt, an die bestimmte Quellenimpedanz der Leistungsquelle anzupassen.

9. Lastanordnung (200), mit folgenden Merkmalen:
einem Belastungszustandsbestimmer (100; 230; 330, 340, 350, 360; 450, 452, 454, 456, 458, 428) gemäß einem der Ansprüche 1 bis 8;
einer einstellbaren Lastschaltung (106; 240; 370; 470; 570; 770) und;
einem Lasteinsteller (250);
wobei die Spannungsabfall-Bestimmungsschaltung des Belastungszustandsbestimmers ausgelegt ist, um den von der Leistungsquelle (104; 210; 310) an die einstellbare Lastschaltung gelieferten Momentanstrom (I_{L}) zu erfassen; und
wobei der Lasteinsteller (250) ausgelegt ist, um die Last in Abhängigkeit von dem Lastzustand-Signal (124; 232; D_{detect}) so einzustellen, dass eine Leistungsanpassung zwischen der Leistungsquelle und der einstellbaren Lastschaltung besteht.

10. Leistungsversorgungsanordnung (104, 100; 200, 210; 300), mit folgenden Merkmalen:
einem elektrischen Generator (104; 210; 310), der ausgelegt ist, um als elektrische Leistungsquelle zu wirken, und um eine von einem Antriebszustand abhängige Leerlaufspannung bereitzustellen,
wobei der elektrische Generator eine Quellenimpedanz aufweist, so dass in einem Belastungsfall eine Klemmenspannung (U_{K}) des elektrischen Generators kleiner als die Leerlaufspannung ist; und
einer Lastanordnung (100; 106; 200; 330; 340, 350, 360, 370; 424, 428, 430, 440, 470) gemäß Anspruch 9;
wobei der Belastungszustandsbestimmer (100; 230; 330, 340, 350, 360) der Lastanordnung ausgelegt ist, um basierend auf einer Erfassung eines von dem elektrischen Generator an die einstellbare Lastschaltung gelieferten Momentanstroms (I_{L}) die elektrische Größe (112; Uₛₑₙₛ), die einen Spannungsabfall an einer Quellenimpedanz der Leistungsquelle beschreibt, so zu liefern, dass diese einen Spannungsabfall an einer Quellenimpedanz des elektrischen Generators beschreibt.

11. Leistungsversorgungsanordnung gemäß Anspruch 10, wobei der elektrische Generator ausgelegt ist, um durch Schwingungen oder Stöße zu einer Bereitstellung einer Spannung angeregt zu werden, so dass ein zeitlicher Verlauf einer Leerlaufspannung des Generators unregelmäßigen zeitlichen Schwankungen unterliegt.

12. Verfahren (800) zum Bestimmen eines Belastungszustands einer elektrischen Leistungsquelle, die eine bekannte Quellenimpedanz aufweist, mit folgenden Schritten:
Bestimmen (810) einer Größe, die einen Spannungsabfall an der bekannten Quellenimpedanz der Leistungsquelle beschreibt, basierend auf einer Erfassung eines unter Last von der Leistungsquelle an eine Last gelieferten Momentanstroms (I_{L}), so dass die Größe, die den Spannungsabfall an der bekannten Quellenimpedanz der Leistungsquelle beschreibt, zu dem Momentanstrom (I_{L}) proportional ist; und
Erhalten (820) eines Lastzustandssignals, das eine Information über eine momentane Relation zwischen der Klemmenspannung der Leistungsquelle und der Leerlaufspannung der Leistungsquelle trägt, basierend auf der Größe, die den Spannungsabfall an dem Innenwiderstand der Leistungsquelle beschreibt, und einer Größe, die die Klemmenspannung der Leistungsquelle beschreibt,
wobei zur Bestimmung der Information über die Relation zwischen der Klemmenspannung der Leistungsquelle und der Leerlaufspannung der Leistungsquelle die elektrische Größe, die den Spannungsabfall an der Quellenimpedanz der Leistungsquelle beschreibt, mit der elektrischen Größe, die die Klemmenspannung der Leistungsquelle beschreibt, verglichen wird; und
wobei das Lastzustandssignal so geliefert wird, dass das Lastzustandssignal (124; 232; D_{detect}) anzeigt, ob die Klemmenspannung (Uₖ) der elektrischen Leistungsquelle zumindest näherungsweise gleich einer Hälfte einer Leerlaufspannung der elektrischen Leistungsquelle ist, oder sich von der Hälfte der Leerlaufspannung um mehr als eine vorbestimmte Toleranz unterscheidet, oder
wobei das Lastzustandssignal so geliefert wird, dass das Lastzustandssignal anzeigt, ob die Klemmenspannung (Uₖ) größer oder kleiner als die Hälfte einer Leerlaufspannung der elektrischen Leistungsquelle (104; 210; 310) ist.

## Claims

1. Loading state determiner (100; 230; 450, 452, 454, 456, 458, 428, 430, 440) for determining a loading state of an electric power source (104; 210; 310), comprising:
a voltage drop determination circuit (110; 330, 340; 450, 452, 454, 456, 458, 428), which is implemented to provide, based on a detection of an instantaneous current (I_{L}) provided under load by the power source to a load (106; 240; 370; 470; 570; 770), an electric quantity (112; Uₛₑₙₛ) describing a voltage drop at the source impedance of the power source and being proportional to the instantaneous current (I_{L}); and
an evaluation circuit (120; 360: 440), which is implemented to obtain, based on the electric quantity describing the voltage drop at the source impedance of the power source and an electric quantity (122; 352; U_{rect/2}) proportional to a terminal voltage (U_{K}) of the power source or to a rectified terminal voltage (U_{K}) of the power source, a load state signal (124; 232; D_{detect}) carrying information on an instantaneous relation between the terminal voltage of the power source and a no-load voltage of the power source,
**characterized in that**
the electric power source (104; 210; 310)comprises a known source impedance;
wherein the evaluation circuit (120; 360; 440) is implemented to compare, for determining the information (124; 232; D_{detect}) on the relation between the terminal voltage (U_{K}) of the power source (104; 210; 310) and the no-load voltage of the power source, the electric quantity (112; Uₛₑₙₛ) describing the voltage drop at the known source impedance of the power source, with the electric quantity (122; 352; U_{rect/2}) that is proportional to the terminal voltage of the power source or to the rectified terminal voltage (U_{K}) of the power source;
wherein the evaluation circuit (120; 360; 440) is implemented to provide the load state signal such that the load state signal (124; 232; D_{detect}) indicates whether the terminal voltage (U_{K}) of the electric power source is at least approximately equal to the half of the no-load voltage of the electric power source or differs by more than a predetermined tolerance from the half of the no-load voltage, or
wherein the evaluation circuit (120; 360; 440) is implemented to provide the load state signal (124; 232; D_{detect}) such that the load state signal indicates whether the terminal voltage (U_{K}) is higher or lower than the half of a no-load voltage of the electric power source (104; 210; 310).

2. Loading state determiner (100; 230; 330, 340, 350, 360; 450, 452, 454, 456, 458, 428, 440, 430) according to claim 1, wherein the loading state determiner is implemented to determine an instantaneous load state signal (124; 232; D_{detect}) based on a quantity (Iₛₑₙₛ) describing an instantaneous current (I_{L}) instantaneously provided to the load (106; 240; 370; 470; 540; 770), and the quantity of the simultaneously applied instantaneous terminal voltage (U_{K}).

3. Loading state determiner (100; 230; 330, 340, 350; 450, 452, 454, 456, 458, 428, 440, 430) according to claim 1 or 2, wherein the loading state determiner is implemented to determine the instantaneous load state signal (124; 232; D_{detect}) based on an evaluation of the quantity of the instantaneous current (I_{L}) instantaneously provided to the load and the quantity of the instantaneous terminal voltage (U_{K}) in a single load state.

4. Loading state determiner (100; 230; 330, 340, 350; 360; 450, 452, 454, 456, 458, 428, 440, 430) according to one of claims 1 to 3, wherein the evaluation circuit (120; 360; 440) is implemented to compare, for determining the information (124; 232; D_{detect}) on the relation between the terminal voltage (U_{K}) of the power source (104; 210; 310) and the no-load voltage of the power source, the electric quantity (112; Uₛₑₙₛ) describing the voltage drop at the source impedance of the power source to the electric quantity (122; 352; U_{rect/2}) describing the terminal voltage of the power source.

5. Loading state determiner (100; 230; 330, 340, 350; 360; 450, 452, 454, 456, 458, 428, 440, 430) according to one of claims 1 to 4, wherein the voltage drop determination circuit (110; 330, 340; 450, 452, 454, 456, 458, 428) is implemented to provide an auxiliary current (Iₛₑₙₛ) proportional to the instantaneous current (I_{L}) provided to the load;
wherein the loading state determiner is implemented such that the instantaneous current (I_{L}) provided to the load differs from an overall current (I_{gen}) provided by the power source (104; 210; 310) by 10 % at the most; and
wherein the voltage drop determination circuit is implemented to generate, based on the auxiliary current (Iₛₑₙₛ) and by using a real-valued or complex-valued impedance member whose value is matched to the real-valued or complex-valued source impedance of the power source (104; 110; 310), a voltage (112; Uₛₑₙₛ) describing the voltage drop at the source impedance of the power source; and
wherein the evaluation circuit (120; 360; 440) is implemented to receive, at a tap of a voltage divider (130; 350; 430), a voltage (122; 352; U_{rect/2}) proportional to the terminal voltage (U_{K}) as the quantity describing the terminal voltage of the power source; and
wherein the evaluation circuit comprises a comparator or differential amplifier (360; 440), which is implemented to receive the voltage (112; Uₛₑₙₛ) describing the voltage drop at the source impedance of the power source and the voltage (122; 352; U_{rect/2}) applied to the tap of the voltage divider as input voltages.

6. Loading state determiner (100; 230; 330, 340, 350; 360; 450, 452, 454, 456, 458, 428, 440, 430) according to one of claims 1 to 5, wherein the voltage drop determination circuit (110; 330, 340; 450, 452, 454, 456, 458, 428) comprises a load control transistor (450), which is implemented to switch or regulate a current flow through the load (106; 240; 370; 470; 570; 770);
wherein the voltage drop determination circuit is implemented to bring a mirror transistor (452) corresponding, as regards to its quality structure, to the load control transistor (450), to an operating point corresponding to the operating point of the load control transistor (450); and
wherein the voltage drop determination circuit is implemented to determine the quantity (112; Uₛₑₙₛ) describing the voltage drop at the source impedance of the power source based on a current flow through the mirror transistor (452) or based on a current flow (Iₛₑₙₛ) proportional to the current flow through the mirror transistor (452).

7. Loading state determiner according to claim 6, wherein the load control transistor (450) and the mirror transistor (452) are switched such that a control voltage of the load control transistor (450) and the mirror transistor (452) are the same, and wherein the voltage drop determination circuit is implemented to imprint a current into the load path of the mirror transistor (452) by using a first current bank transistor (456) and to regulate the imprinted current such that a load path voltage of the mirror transistor (452), apart from a regulation inaccuracy, is equal to a load path voltage of the load control transistor (450); and
wherein the voltage drop determination circuit is implemented to provide, by using a second current bank transistor (458), a current proportional to the current provided by the first current bank transistor (456) and to convert the current (Iₛₑₙₛ) provided by the second current bank transistor (456) into a voltage (Uₛₑₙₛ) describing the voltage drop at the source impedance of the power source.

8. Loading state determiner (100; 230; 330, 340, 350; 360) according to one of claims 1 to 7, wherein the voltage drop determination circuit (110; 330, 340) comprises a source impedance determiner, which is implemented to determine the source impedance of the power source and to match the provision of the electric quantity (112; Uₛₑₙₛ) describing the voltage drop at the source impedance of the power source to the determined source impedance of the power source.

9. Load assembly (200), comprising:
a loading state determiner (100; 230; 330, 340, 350; 360; 450, 452, 454, 456, 458, 428) according to one of claims 1 to 8;
an adjustable load circuit (106; 240; 370; 470; 570; 770) and;
a load adjuster (250);
wherein the voltage drop determination circuit of the loading state determiner is implemented to detect the instantaneous current (I_{L}) provided by the power source (104; 210; 310) to the adjustable load circuit; and
wherein the load adjuster (250) is implemented to adjust the load in dependence on the load state signal (124; 232; D_{detect}) such that power matching exists between the power source and the adjustable load circuit.

10. Power supply assembly (104, 100; 200, 210; 300), comprising:
an electric generator (104; 210; 310), which is implemented to act as electric power source and to provide a no-load voltage depending on a drive state,
wherein the electric generator comprises a source impedance, such that, in a loading case, a terminal voltage (U_{K}) of the electric generator is lower than the no-load voltage; and
a load assembly (100; 106; 200; 330; 340, 350, 360, 370; 424, 428, 430, 440, 470) according to claim 9;
wherein the loading state determiner (100; 230; 330, 340, 350, 360) of the load assembly is implemented to provide, based on a detection of an instantaneous current (I_{L}) provided by the electric generator to the adjustable load circuit, the electric quantity (112; Uₛₑₙₛ) describing a voltage drop at a source impedance of the power source, such that the same describes a voltage drop at a source impedance of the electric generator.

11. Power supply assembly according to claim 10, wherein the electric generator is implemented to be excited by vibrations or impacts to provide a voltage, such that a time curve of a no-load voltage of the generator is subject to irregular temporal variations.

12. Method (800) for determining a loading state of an electric power source comprising a source impedance, comprising:
determining (810) a quantity describing a voltage drop at the known source impedance of the power source, based on a detection of an instantaneous current (I_{L}) provided under load by the power source to a load, such that the quantity describing the voltage drop at the known source impedance of the power source is proportional to the instantaneous current (I_{L}); and
obtaining (820) a load state signal carrying information on an instantaneous relation between the terminal voltage of the power source and the no-load voltage of the power source, based on the quantity describing the voltage drop at the internal resistance of the power source and a quantity describing the terminal voltage of the power source,
wherein, for determining the information on the relation between the terminal voltage of the power source and the no-load voltage of the power source, the electric quantity describing the voltage drop at the source impedance of the power source is compared to the electric quantity describing the terminal voltage of the power source; and
wherein the load state signal is provided such that the load state signal (124; 232; D_{detect}) indicates whether the terminal voltage (U_{K}) of the electric power source is at least approximately equal to a half of a no-load voltage of the electric power source or differs from the half of the no-load voltage by more than a predetermined tolerance, or
wherein the load state signal is provided such that the load state signal indicates whether the terminal voltage (U_{K}) is higher or lower than the half of a no-load voltage of the electric power source (104; 210; 310).

## Revendications

1. Déterminateur d'état de charge (100; 230; 450, 452, 454, 456, 458, 428, 430, 440) pour déterminer un état de charge d'une source de puissance électrique (104; 210; 310), aux caractéristiques suivantes:
un circuit de détermination de chute de tension (110; 330; 340; 450, 452, 454, 456, 458, 428) qui est conçu pour fournir, sur base d'une détection d'un courant momentané (I_{L}) fourni sous charge de la source de puissance à une charge (106; 240; 370; 470; 570; 770), une grandeur électrique (112; Uₛₑₙₛ) décrivant une chute de tension à l'impédance de source de la source de puissance et qui est proportionnelle au courant momentané (I_{L}); et
un circuit d'évaluation (120; 360; 440) qui est conçu pour obtenir, sur base de la grandeur électrique décrivant la chute de tension à l'impédance de source de la source de puissance et d'une grandeur électrique (122; 352 U_{rect/2}) qui est proportionnelle à une tension de borne (Uₖ) de la source de puissance ou à une tension de borne (Uₖ) redressée de la source de puissance, un signal d'état de charge (124; 232; D_{detect}) qui porte une information sur un rapport momentané entre la tension de borne de la source de puissance et une tension à vide de la source de puissance,
**caractérisé par le fait que**
la source de puissance électrique (104; 210; 310) présente une impédance de source connue;
le circuit d'évaluation (120; 360; 440) est réalisé pour comparer, pour déterminer l'information (124; 232; D_{detect}) sur le rapport entre la tension de borne (Uₖ) de la source de puissance (104; 210; 310) et la tension à vide de la source de puissance, la grandeur électrique (112; Uₛₑₙₛ) décrivant la chute de tension à l'impédance de source connue de la source de puissance avec la grandeur électrique (122; 352 U_{rect/2}) qui est proportionnelle à la tension de borne de la source de puissance ou à la tension de borne (Uₖ) redressée de la source de puissance;
dans lequel le circuit d'évaluation (120; 360; 440) est réalisé pour fournir le signal d'état de charge de sorte que le signal d'état de charge (124; 232; D_{detect}) indique si la tension de borne (Uₖ) de la source de puissance électrique est au moins environ égale à la moitié de la tension à vide de la source de puissance électrique ou diffère de la moitié de la tension à vide de plus une tolérance prédéterminée, ou
dans lequel le circuit d'évaluation (120; 360; 440) est réalisé pour fournir le signal d'état de charge (124; 232; D_{detect}) de sorte que le signal d'état de charge indique si la tension de borne (Uₖ) est supérieure ou inférieure à la moitié d'une tension à vide de la source de puissance électrique (104; 210; 310).

2. Déterminateur d'état de charge (100; 230; 330; 340, 350, 360; 450, 452, 454, 456, 458, 428, 440, 430) selon la revendication 1, dans lequel le déterminateur d'état de charge est conçu pour déterminer un signal d'état de charge momentané (124; 232; D_{detect}) sur base d'une grandeur (Iₛₑₙₛ) décrivant un courant momentané (I_{L}) fourni momentanément à la charge (106; 240; 370; 470; 570; 770) et de la grandeur de la tension de borne momentanée (Uₖ) présente en même temps.

3. Déterminateur d'état de charge (100; 230; 320, 330, 340, 350 ; 450, 452, 454, 456, 458, 428, 440, 430) selon la revendication 1 ou 2, dans lequel le déterminateur d'état de charge est réalisé pour déterminer le signal d'état de charge momentané (124; 232; D_{detect}) sur base d'une évaluation de la grandeur du courant momentané (I_{L}) fourni momentanément à la charge et de la grandeur de la tension de borne momentanée (Uₖ) dans un seul état de charge.

4. Déterminateur d'état de charge (100; 230; 330, 340, 350; 360; 450, 452, 454, 456, 458, 428, 440, 430) selon l'une des revendications 1 à 3, dans lequel le circuit d'évaluation (120; 360; 440) est conçu pour comparer, pour déterminer l'information (124; 232; D_{detect}) sur le rapport entre la tension de borne (Uₖ) de la source de puissance (104; 210; 310) et la tension à vide de la source de puissance, la grandeur électrique (112; Uₛₑₙₛ) décrivant la chute de tension à l'impédance de source de la source de puissance avec la grandeur électrique (122; 352 U_{rect/2}) décrivant la tension de borne de la source de puissance.

5. Déterminateur d'état de charge (100; 230; 330, 340, 350; 360; 450, 452, 454, 456, 458, 428, 440, 430) selon l'une des revendications 1 à 4, dans lequel le circuit de détermination de chute de tension (110; 330, 340; 450, 452; 454, 456, 458, 428) est réalisé pour mettre à disposition un courant auxiliaire (Iₛₑₙₛ) proportionnel à un courant momentané (I_{L}) fourni à la charge;
dans lequel le déterminateur d'état de charge est réalisé de sorte que le courant momentané (I_{L}) fourni à la charge diffère d'un courant (I_{gen}) fourni au total par la source de puissance (104; 210; 310) de tout ou plus 10%; et
dans lequel le circuit de détermination de chute de tension est réalisé pour générer, sur base du courant auxiliaire (Iₛₑₙₛ) et à l'aide d'un élément d'impédance de valeur réelle ou de valeur complexe dont la valeur est adaptée à l'impédance de source de valeur réelle ou de valeur complexe de la source de puissance (104; 110; 310), une tension (112; Uₛₑₙₛ) décrivant la chute de tension à l'impédance de source de la source de puissance; et
dans lequel le circuit d'évaluation (120; 360; 440) est réalisé pour recevoir, à un prélèvement d'un diviseur de tension (130; 350; 430), une tension (122; 352; U_{rect/2}) proportionnelle à la tension de borne (Uₖ) comme grandeur décrivant la tension de borne de la source de puissance; et
dans lequel le circuit d'évaluation présente un comparateur ou amplificateur de différence (360; 440) qui est réalisé pour recevoir, comme tensions d'entrée, la tension (112; Uₛₑₙₛ) décrivant la chute de tension à l'impédance de source de la source de puissance et la tension (122; 352; U_{rect/2}) présente au prélèvement du diviseur de tension.

6. Déterminateur d'état de charge (100; 230; 330, 340, 350; 360; 450, 452, 454, 456, 458, 428, 440, 430) selon l'une des revendications 1 à 5, dans lequel le circuit de détermination de chute de tension (110; 330, 340; 450, 452, 454, 456, 458, 428) présente un transistor de commande de charge (450) qui est conçu pour commuter ou régler un flux de courant à travers la charge (106; 240; 370; 470; 570; 770);
dans lequel le circuit de détermination de chute de tension est réalisé pour amener un transistor miroir (452), qui correspond de par sa structure qualitative au transistor de commande de charge (450), à un point de fonctionnement qui correspond au point de fonctionnement du transistor de commande de charge (450); et
dans lequel le circuit de détermination de chute de tension est réalisé pour déterminer la grandeur (112; Uₛₑₙₛ) décrivant la chute de tension à l'impédance de source de la source de puissance sur base d'un flux de courant passant par le transistor miroir (452) ou sur base d'un flux de courant (Iₛₑₙₛ) proportionnel au flux de courant passant par le transistor miroir (452).

7. Déterminateur d'état de charge selon la revendication 6, dans lequel le transistor de commande de charge (450) et le transistor miroir (452) sont connectés de sorte qu'une tension de commande du transistor de commande de charge (450) et du transistor miroir (452) soient identiques, et
dans lequel le circuit de détermination de chute de tension est réalisé pour imprimer un courant dans le trajet de charge du transistor miroir (452) à l'aide d'un premier transistor de banque de courant (456), et pour réguler le courant imprimé de sorte qu'une tension de trajet de charge du transistor miroir (452), sauf une précision de régulation, soit identique à une tension de trajet de charge du transistor de commande de charge (450); et
dans lequel le circuit de détermination de chute de tension est réalisé pour mettre à disposition, à l'aide d'un deuxième transistor de banque de courant (458), un courant proportionnel au courant fourni par le premier transistor de banque de courant (456), et pour convertir le courant (Iₛₑₙₛ) fourni par le deuxième transistor de banque de courant (456) en une tension (Uₛₑₙₛ) décrivant la chute de tension à l'impédance de source de la source de puissance.

8. Déterminateur d'état de charge (100; 230; 330, 340, 350; 360) selon l'une des revendications 1 à 7, dans lequel le circuit de détermination de chute de tension (110; 330, 340) présente un déterminateur d'impédance de source qui est réalisé pour déterminer l'impédance de source de la source de puissance, et pour adapter la mise à disposition de la grandeur électrique (112; Uₛₑₙₛ) décrivant la chute de tension à l'impédance de source de la source de puissance à l'impédance de source déterminée de la source de puissance.

9. Ensemble de charge (200), aux caractéristiques suivantes:
un déterminateur d'état de charge (100; 230; 330, 340, 350, 360; 450, 452, 454, 456, 458, 428) selon l'une des revendications 1 à 8;
un circuit de charge réglable (106; 240; 370; 470; 570; 770); et
un régleur de charge (250);
dans lequel le circuit de détermination de chute de tension du déterminateur d'état de charge est réalisé pour détecter le courant momentané (I_{L}) fourni par la source de puissance (104; 210; 310) au circuit de charge réglable; et
dans lequel le régleur de charge (250) est réalisé pour régler la charge en fonction du signal d'état de charge (124; 232; D_{detect}) de sorte qu'il existe une adaptation de puissance entre la source de puissance et le circuit de charge réglable.

10. Ensemble d'alimentation de puissance (104, 100; 200, 210; 300), aux caractéristiques suivantes:
un générateur électrique (104; 210; 310) qui est réalisé pour fonctionner comme source de puissance électrique et pour mettre à disposition une tension à vide fonction d'un état d'entraînement,
dans lequel le générateur électrique présente une impédance de source de sorte que, en cas de charge, une tension de borne (Uₖ) du générateur électrique soit plus petite que la tension à vide; et
un ensemble de charge (100; 106; 200; 330; 340, 350, 360, 370; 424, 428, 430, 440, 470) selon la revendication 9;
dans lequel le déterminateur d'état de charge (100; 230; 330, 340, 350, 360) de l'ensemble de charge est réalisé pour fournir, sur base d'une détection d'un courant momentané (I_{L}) fourni par le générateur électrique au circuit de charge réglable, la grandeur électrique (112; Uₛₑₙₛ) décrivant une chute de tension à une impédance de source de la source de puissance de sorte qu'elle décrive une chute de tension à une impédance de source du générateur électrique.

11. Ensemble d'alimentation selon la revendication 10, dans lequel le générateur électrique est réalisé pour être excité par des oscillations ou des chocs pour une mise à disposition d'une tension de sorte qu'une évolution temporelle d'une tension à vide du générateur soit soumise à des variations temporelles irrégulières.

12. Procédé (800) pour déterminer un état de charge d'une source de puissance électrique qui présente une impédance de source connue, aux étapes suivantes consistant à:
déterminer (810) une grandeur décrivant une chute de tension à l'impédance des source connue de la source de puissance sur base d'une détection d'un courant momentané (I_{L}) fourni sous charge par la source de puissance à une charge, de sorte que la grandeur décrivant la chute de tension à l'impédance de source connue de la source de puissance soit proportionnelle au courant momentané (I_{L}); et
obtenir (820) un signal d'état de charge portant une information sur un rapport momentané entre la tension de borne de la source de puissance et la tension à vide de la source de puissance sur base de la grandeur décrivant la chute de tension à la résistance intérieure de la source de puissance et d'une grandeur décrivant la tension de borne de la source de puissance,
dans lequel, pour déterminer l'information sur le rapport entre la tension de borne de la source de puissance et la tension à vide de la source de puissance, la grandeur électrique décrivant la chute de tension à l'impédance de source de la source de puissance est comparée avec la grandeur électrique décrivant la tension de borne de la source de puissance; et
dans lequel le signal d'état de charge est fourni de sorte que le signal d'état de charge (124; 232; D_{detect}) indique si la tension de borne (Uₖ) de la source de puissance électrique est au moins environ égale à une moitié d'une tension à vide de la source de puissance électrique, ou diffère de la moitié de la tension à vide de plus d'une tolérance prédéterminée, ou
dans lequel le signal d'état de charge est fourni de sorte que le signal d'état de charge indique si la tension de borne (Uₖ) est supérieure ou inférieure à la moitié d'une tension à vide de la source de puissance électrique (104; 210; 310).
